(19) 

Europäisches
Patentamt
European
Patent Office
Office européen
des brevets

(11)  **EP 4 629 514 A1**

(12) **EUROPEAN PATENT APPLICATION**
published in accordance with Art. 153(4) EPC

(43) Date of publication:
**08.10.2025 Bulletin 2025/41**

(21) Application number: **23899761.3**

(22) Date of filing: **21.11.2023**

(51) International Patent Classification (IPC):
*H03M 13/13* (2006.01)

(52) Cooperative Patent Classification (CPC):
**H03M 13/13; H04L 1/00**

(86) International application number:
**PCT/CN2023/132941**

(87) International publication number:
**WO 2024/120182 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **06.12.2022 CN 202211557600**

(71) Applicant: **ZTE Corporation
Shenzhen, Guangdong 518057 (CN)**

(72) Inventors:
• **LIANG, Chulong
Shenzhen, Guangdong 518057 (CN)**
• **ZHAO, Wei
Shenzhen, Guangdong 518057 (CN)**
• **XU, Jin
Shenzhen, Guangdong 518057 (CN)**
• **LI, Liguang
Shenzhen, Guangdong 518057 (CN)**

(74) Representative: **Savi, Massimiliano et al
Notarbartolo & Gervasi S.p.A.
Viale Achille Papa, 30
20149 Milano (IT)**

(54) **DATA PROCESSING METHOD AND APPARATUS, DEVICE, AND STORAGE MEDIUM**

(57) The present application discloses a data processing method and apparatus, a device, and a storage medium, wherein the method comprises: according to Gray mapping rules, mapping information bits located in an information bit sequence to an information and frozen bit sequence, and then encoding the information and frozen bit sequence to obtain an encoded data sequence.

| First transmission node 110 | Encoded data sequence → | Second transmission node 120 |

FIG. 2

Acquire an information bit sequence, where the information bit sequence includes K information bits, and K is an integer greater than 0 — S100

Map information bits in the information bit sequence to an information and frozen bit sequence according to a Gray mapping rule, where the information and frozen bit sequence includes N bits, N represents a number of polarized subchannels, and N is an integer greater than K — S200

Encode the information and frozen bit sequence to obtain an encoded data sequence — S300

Send the encoded data sequence — S400

FIG. 3

EP 4 629 514 A1

**Description**

**CROSS-REFERENCE TO RELATED APPLICATION**

This application is filed on the basis of Chinese patent application No. 202211557600.9 filed December 06, 2022, and claims priority to the Chinese patent application, the entire contents of which are incorporated herein by reference.

**TECHNICAL FIELD**

The present disclosure relates to the field of communication technologies, and in particular, to a data processing method and apparatus, a device, and a storage medium.

**BACKGROUND**

Since having higher reliability in short codes, polar codes are adopted in 5th Generation Mobile Communication (5G) standards formulated by the 3rd Generation Partnership Project (3GPP) as encoding schemes for 5G NR control messages, specifically, Downlink Control Information (DCI) and Uplink Control Information (UCI) in control channels, and broadcast information carried by Physical Broadcast Channels (PBCHs).

A polar code sequence is used to indicate a bit selection order before polar coding, i.e., "best-channel selection". To enable polar codes to support the flexible code length and code rate requirements of 5G NR control messages, a sufficiently practical subchannel reliability sorting sequence needs to be designed. A Polar Weight (PW) sequence demonstrates that a polar code sequence can be independent of channel parameters from the perspective of standardization and practicality, which makes the PW sequence exhibit desirable and stable performance under various code length and code rate configurations.

In practical applications, after polar weights are calculated, the polar weights may be sorted in ascending order, and then sequence numbers of input bits originally corresponding to the polar weights can be found, thus obtaining a PW sequence. If the PW sequence is calculated in real time, high precision is required in the calculation of polar weights, resulting in the consumption of a lot of memory transistors. If the PW sequence is acquired from a memory, a PW sequence having a size of $N_{max}$ needs to be stored in the memory. For a polar code having a number N of polarized subchannels, a sub-sequence formed by the first N elements is sequentially extracted from the PW sequence having a size of $N_{max}$ to form a reliability sorting sequence of N subchannels, where N is less than or equal to $N_{max}$. Although this method reduces the overhead of online computing resources, it increases the storage overhead.

**SUMMARY**

The present disclosure discloses a data processing method and apparatus, a device, and a storage medium, to reduce the overhead of storage resources used in polar coding.

In accordance with a first aspect of the present disclosure, an embodiment provides a data processing method, including:

acquiring an information bit sequence, where the information bit sequence includes K information bits, and K is an integer greater than 0;
mapping information bits in the information bit sequence to an information and frozen bit sequence according to a Gray mapping rule, where the information and frozen bit sequence includes N bits, N represents a number of polarized subchannels, and N is an integer greater than K;
encoding the information and frozen bit sequence to obtain an encoded data sequence; and
sending the encoded data sequence.

In accordance with a second aspect of the present disclosure, an embodiment provides a data processing method, including:

receiving an encoded data sequence sent by a transmit end, where the encoded data sequence includes N pieces of encoded data, and
the encoded data sequence is obtained by performing the following operations: mapping information bits in an information bit sequence to an information and frozen bit sequence according to a Gray mapping rule, and encoding the information and frozen bit sequence to obtain the encoded data sequence, where the information bit sequence includes K information bits, K is an integer greater than 0, the information and frozen bit sequence includes N bits, N represents a number of polarized subchannels, and N is an integer greater than K.

In accordance with a third aspect of the present disclosure, an embodiment provides an electronic device, including:

> at least one processor; and
> at least one memory, configured for storing at least one program,
> where the at least one program, when executed by the at least one processor, causes the at least one processor to implement the data processing method in accordance with the first aspect or the second aspect.

In accordance with a fourth aspect of the present disclosure, an embodiment provides a computer-readable storage medium, storing a processor-executable program, where the processor-executable program, when executed by a processor, causes the processor to implement the data processing method in accordance with the first aspect or the second aspect.

In accordance with a fifth aspect of the present disclosure, an embodiment provides a computer program product, including a computer program or a computer instruction stored in a computer-readable storage medium, where the computer program or computer instruction, when read from the computer-readable storage medium and executed by a processor of a computer device, causes the computer device to implement the data processing method in accordance with the first aspect or the second aspect.

According to the embodiments of the present disclosure, information bits in an information bit sequence are mapped to an information and frozen bit sequence according to a Gray mapping rule, and the information and frozen bit sequence is encoded to obtain an encoded data sequence. Subchannels for transmitting information bits or frozen bits are determined online by Gray mapping, and the information and frozen bit sequence is encoded, to reduce computing resources required for obtaining subchannel reliability while reducing the storage overhead.

## BRIEF DESCRIPTION OF DRAWINGS

> FIG. 1a is a schematic diagram of a logic code for adding frozen bits;
> FIG. 1b is a plot of polar transformation factors when N=16;
> FIG. 2 is a schematic architectural diagram of a communication system to which embodiments of the present disclosure are applicable;
> FIG. 3 is a schematic flowchart of a data processing method according to an embodiment of the present disclosure;
> FIGS. 4 to 12 are each a schematic diagram of a logic code for updating an information and frozen bit sequence according to an embodiment of the present disclosure;
> FIGS. 13 to 14 are each a schematic diagram of a logic code for serial encoding according to an embodiment of the present disclosure;
> FIG. 15 is a schematic flowchart of another multimedia data processing method according to an embodiment of the present disclosure;
> FIG. 16 is a schematic structural diagram of a data processing apparatus according to an embodiment of the present disclosure; and
> FIG. 17 is a schematic structural diagram of an electronic device according to an embodiment of the present disclosure.

## DETAILED DESCRIPTION

The present disclosure will be further described below in conjunction with the accompanying drawings of the specification and specific embodiments.

In the following descriptions, the term "some embodiments" describes subsets of all possible embodiments, but it may be understood that "some embodiments" may be the same subset or different subsets of all the possible embodiments, and can be combined with each other without conflict.

Unless otherwise defined, meanings of all technical and scientific terms used in this specification are the same as those usually understood by those having ordinary skills in the art to which the present disclosure belongs. Terms used in this specification are merely intended to describe objectives of the embodiments of the present disclosure, but are not intended to limit the present disclosure.

For ease of understanding of the schemes of the embodiments of the present disclosure, terms involved in the embodiments of the present disclosure will be explained first.

(1) Polar Weight (PW) sequence:

For the PW sequence, a formula for calculating reliability of a polarized subchannel corresponding to an index bit i is:

$$W_i = \sum_{j=0}^{n-1} B_j \cdot 2^{j/4} \quad \text{(formula 1)}$$

where $W_i$ is a polar weight used on an $i^{th}$ input bit ($i^{th}$ subchannel); i represents a sequence number of the input bit, where for a polar code with a number of polarized subchannels being N = $2^n$, i = 0, 1, 2, ..., N-2, N-1; N is a number of bits required to express the integer N in a binary form; $B_j$ represents a $j^{th}$ bit corresponding to the integer i in the binary form and has a value of bit 0 or bit 1, where j = 0, 1, 2, ..., n-2, n-1; and a binary expression of i is i = $B_{n-1}B_{n-2}...B_2B_1B_0$, with $B_0$ being the lowest bit.

It should be noted that a quantization weight value sequence β = [$β_{n-1}$, $β_{n-2}$, ..., $β_0$] calculated according to a number of polarized subchannels $N_{max}$ = $2^n$ may be used for polar codes with a number of polarized subchannels being N = $2^t$, where t = n, n-1, n-2, ..., 1. For example, a quantization weight value sequence β = [$β_9$, $β_8$, ..., $β_0$] is calculated according to n=10 and $N_{max}$=1024, and this configuration can be used for polar coding with a polarized subchannel length N = 1024, 512, 256, 128, ..., so N may be less than or equal to $2^n$. For convenience of description, in the scheme of the embodiments of the present disclosure, $N_{max}$ is described as N, and N = $2^n$.

Table 1 provides a PW sequence with N = 16, i.e., PW = [0, 1, 2, 4, 8, 3, 5, 6, 9, 10, 12, 7, 11, 13, 14, 15], where the first element "0" represents an index number of a subchannel with lowest reliability, and the last element "15" represents an index number of a subchannel with highest reliability.

Table 1 PW sequence having a length of N = 16

| $W_i$ | i | $W_i$ | i | $W_i$ | i | $W_i$ | i |
|---|---|---|---|---|---|---|---|
| 0.0000 | 0 | 1.6818 | 8 | 2.6818 | 9 | 3.8710 | 11 |
| 1.0000 | 1 | 2.1892 | 3 | 2.8710 | 10 | 4.0960 | 13 |
| 1.1892 | 2 | 2.4142 | 5 | 3.0960 | 12 | 4.2852 | 14 |
| 1.4142 | 4 | 2.6034 | 6 | 3.6034 | 7 | 5.2852 | 15 |

(2) Polar code encoding

Assuming that a = [$a_0$, $a_1$, ..., $a_{k-1}$], a is an information sequence having a length of K, and N is the number of polarized subchannels, a process of encoding the information sequence a into a codeword d = [$d_0$, $d_1$, ..., $d_{N-1}$] having a length of N is as follows.

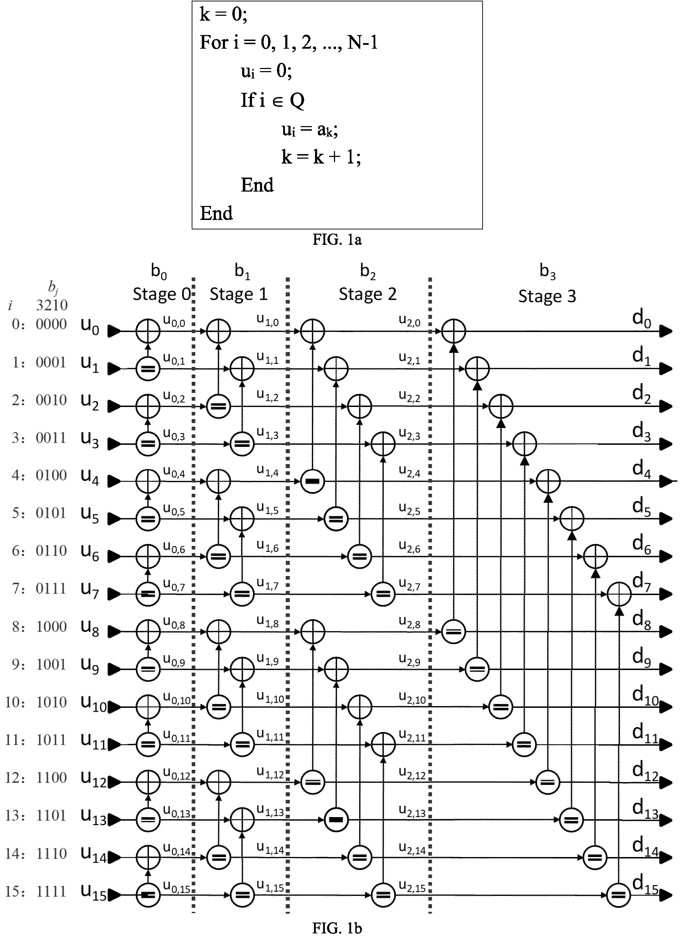

(1) Addition of frozen bits: An appropriate subchannel for carrying information bits and an appropriate subchannel for placing frozen bits are selected. N-K bits 0 are added to the information sequence a = [$a_0$, $a_1$, ..., $a_{k-1}$] to obtain a sequence u = [$u_0$, $u_1$, ..., $u_{N-1}$]. For example, the process of adding frozen bits may be implemented by a logic code shown in FIG. 1a.

Polar transformation: The sequence u and a polarization matrix $G_N$ of N rows and N columns are multiplied on GF(2) to obtain a codeword d = u·$G_N$, where $\mathbf{G}_N = \begin{bmatrix} \mathbf{G}_{N/2} & 0 \\ \mathbf{G}_{N/2} & \mathbf{G}_{N/2} \end{bmatrix}$, $\mathbf{G} = \begin{bmatrix} 1 & 0 \\ 1 & 1 \end{bmatrix}$. FIG. 1b is a plot of polar transformation factors when N=16.

(3) Gray code

Gray code is a binary numeral system where any two adjacent values differ by only one binary digit. There are many encoding forms of Gray codes. An example of a typical Gray code is shown in Table 2.

Table 2 Comparison table between natural decimal numbers and 4-digit typical Gray codes

| Natural decimal number i | 4-bit natural binary code | 4-bit typical Gray code | Gray code decimal number $g_i$ | Natural decimal number i | 4-bit natural binary code | 4-bit typical Gray code | Gray code decimal number $g_i$ |
|---|---|---|---|---|---|---|---|
| 0 | 0000 | 0000 | 0 | 8 | 1000 | 1100 | 12 |
| 1 | 0001 | 0001 | 1 | 9 | 1001 | 1101 | 13 |
| 2 | 0010 | 0011 | 3 | 10 | 1010 | 1111 | 15 |
| 3 | 0011 | 0010 | 2 | 11 | 1011 | 1110 | 14 |
| 4 | 0100 | 0110 | 6 | 12 | 1100 | 1010 | 10 |
| 5 | 0101 | 0111 | 7 | 13 | 1101 | 1011 | 11 |
| 6 | 0110 | 0101 | 5 | 14 | 1110 | 1001 | 9 |
| 7 | 0111 | 0100 | 4 | 15 | 1111 | 1000 | 8 |

In the present disclosure, a process of mapping a natural decimal number i to a typical Gray code decimal number $g_i$ in Table 2 is referred to as Gray mapping. If a Gray code decimal number $g_{i-1}$ corresponding to a natural decimal number i-1 is known, the Gray code decimal number $g_i$ corresponding to the natural decimal number i may be calculated according to the following formula.

$$g_i = g_{i-1} + (1 - 2 \cdot B_{e+1}) \cdot 2^e \quad \text{(Formula 2)}$$

where the natural decimal number i is expressed in binary form as $i = B_{n-1}B_{n-2}...B_2B_1B_0$; $B_j$ represents a $j^{th}$ bit corresponding to the integer i in the binary form and has a value of bit 0 or bit 1, where j = 0, 1, 2, ..., n-2, n-1; and e is a position where 1 first appears starting from a $0^{th}$ bit $B_0$ of $B_{n-1}B_{n-2}...B_2B_1B_0$ (i.e., $B_e = 1$ and $B_{e-1} = B_{e-2} = ..., = B_0 = 0$), $B_e$ is a bit value of this position, $B_{e+1}$ is a bit value of an $(e+1)^{th}$ bit, and e E {0, 1, ..., n-1}. A current Gray code decimal number $g_i$ can be quickly obtained according to a previous Gray code decimal number $g_{i-1}$, thereby reducing the amount of calculation.

Similarly, if a Gray code decimal number $g_{i+1}$ corresponding to a natural decimal number i+1 is known, the Gray code decimal number $g_i$ corresponding to the natural decimal number i can be calculated according to $g_{1+1}$, as shown by the following formula:

$$g_i = g_{i+1} - (1 - 2 \cdot B_{e+1}) \cdot 2^e \quad \text{(Formula 3)}$$

where the natural decimal number i+1 is expressed in binary form as $i+1 = B_{n-1}B_{n-2}...B_2B_1B_0$; $B_j$ represents a $j^{th}$ bit corresponding to the integer i+1 in the binary form and has a value of bit 0 or bit 1, where j = 0, 1, 2, ..., n-2, n-1; and e is a position where 1 first appears starting from a $0^{th}$ bit $B_0$ of $B_{n-1}B_{n-2}...B_2B_1B_0$ (i.e., $B_e = 1$ and $B_{e-1} = B_{e-2} = ..., = B_0 = 0$), $B_e$ is a bit value of this position, $B_{e+1}$ is a bit value of an $(e+1)^{th}$ bit, and e ∈ {0, 1, ..., n-1}. A current Gray code decimal number $g_i$ can be quickly obtained according to a previous Gray code decimal number $g_{i+1}$, thereby reducing the amount of calculation.

In the 5G standard protocol TS 38.212 formulated by 3GPP, polar code sequences and corresponding reliability are given in a table. When the code length is N, a memory having $\log_2(N)*N$ bits is required to store the polar code sequence. In the encoding process of encoding the information sequence a into a codeword d having a length of N, first, N-K bits 0 are added to the information sequence $a = [a_0, a_1, ..., a_{k-1}]$ according to the polar code sequence to obtain a sequence $u = [u_0, u_1,..., u_{N-1}]$; then the sequence u is used as an input of polarization transformation, to obtain the codeword d having a length of N through logical operation. To reduce the storage overhead, the present disclosure provides a data processing method for online calculating reliability of subchannels and determining a position of information bits based on Gray mapping.

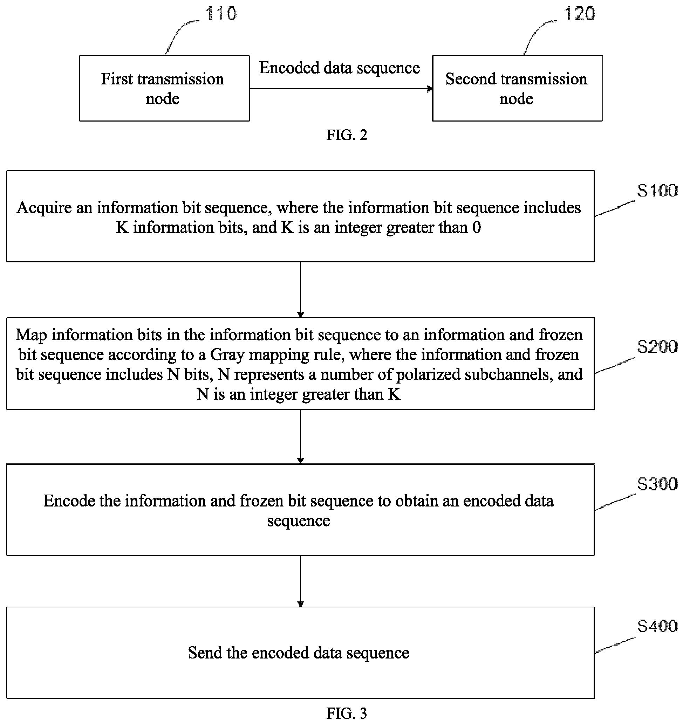

FIG. 2 is a schematic architectural diagram of a communication system to which embodiments of the present disclosure are applicable. The communication system shown in FIG. 2 includes a first transmission node 110 and a second transmission node 120. The first transmission node 110 is connected to the second transmission node 120. The first transmission node 110 sends an encoded data sequence to the second transmission node 120. The first transmission node 110 and the second transmission node 120 may include, but not limited to, one of the following devices: a Base Station (BS), an Access Point (AP), a NodeB, a generalized Node B (g NodeB), a Radio Network Controller (RNC), an Evolved NodeB (eNB), a Base Station Controller (BSC), a Base Transceiver Station (BTS), a Transceiver Function (TF), a radio router, a radio transceiver, a Basic Service Set (BSS), an Extended Service Set (ESS), or a Radio Base Station (RBS), which is not particularly limited in the embodiments of the present disclosure.

In a feasible implementation, the first transmission node 110 and the second transmission node 120 may be referred to as an access terminal, a User Equipment (UE), a subscriber unit, a subscriber station, a mobile station, a mobile, a remote station, a remote terminal, a mobile device, a user terminal, a wireless communication device, a user agent, or a user device. For example, the first transmission node 110 and the second transmission node 120 may be a cellular phone, a cordless telephone, a Session Initiation Protocol (SIP) telephone, a Wireless Local Loop (WLL) station, a Personal Digital Assistant (PDA), a handheld device with a wireless communication function, a computing device or other processing device connected to a wireless modem, a vehicle-mounted device, a wearable device, a terminal device in a 5G network or future evolved networks, etc., which is not limited in the embodiments of the present disclosure.

In accordance with a first aspect of the present disclosure, an embodiment provides a data processing method, which can be applied to the first transmission node 110 shown in FIG. 2. FIG. 3 is a schematic flowchart of the data processing method in accordance with the first aspect of the present disclosure. As shown in FIG. 3, the data processing method includes the following steps S100-S400, which will be sequentially described below.

At S100, an information bit sequence is acquired, where the information bit sequence includes K information bits, and K is an integer greater than 0.

At S200, information bits in the information bit sequence are mapped to an information and frozen bit sequence according to a Gray mapping rule, where the information and frozen bit sequence includes N bits, N represents a number of polarized subchannels, and N is an integer greater than K.

At S300, the information and frozen bit sequence is encoded to obtain an encoded data sequence.

At S400, the encoded data sequence is sent.

For example, the information bit sequence may be expressed as $a = [a_0, a_1, ..., a_{k-1}]$, the information and frozen bit sequence may be expressed as $u = [u_0, u_1, ..., u_{N-1}]$, and the encoded data sequence may be expressed as $d = [d_0, d_1, ..., d_{N-1}]$. According to the embodiments of the present disclosure, information bits in an information bit sequence a are mapped to an information and frozen bit sequence u according to a Gray mapping rule, and the information and frozen bit sequence is encoded to obtain an encoded data sequence d. Subchannels for transmitting information bits or frozen bits are determined online by Gray mapping, and the information and frozen bit sequence is encoded, to reduce computing resources required for obtaining subchannel reliability while reducing the storage overhead.

For example, in S200, mapping information bits in the information bit sequence to an information and frozen bit sequence according to a Gray mapping rule may be implemented by performing the following steps S210 to S240.

At S210, the information bits in the information bit sequence are mapped to an initial information and frozen bit sequence.

At S220, a subchannel reliability value corresponding to each of the polarized subchannels is determined according to the Gray mapping rule, a natural order subchannel index number, and a quantization weight value sequence.

At S230, an information and frozen bit indication corresponding to each of the polarized subchannels is determined according to the subchannel reliability values corresponding to the polarized subchannels and a reliability threshold.

At S240, the initial information and frozen bit sequence is updated according to the information and frozen bit indications corresponding to the polarized subchannel to obtain the information and frozen bit sequence.

For example, in S210, mapping the information bits in the information bit sequence to an initial information and frozen bit sequence may be implemented in, for example, but not limited to, any one of the following manners.

Manner 1: A $j^{th}$ information bit $a_j$ in the information bit sequence is set at a $g_{N-K+j}^{th}$ position in the initial information and frozen bit sequence, where j is any integer from 0 to K-1, and $g_{N-K+j}$ represents a Gray code decimal number corresponding to (N-K+j).

Manner 2: A $(K-1-j)^{th}$ information bit $a_{K-1-j}$ in the information bit sequence is set at a $g_{N-K+j}^{th}$ position in the initial information and frozen bit sequence, where j is any integer from 0 to K-1, and $g_{N-K+j}$ represents a Gray code decimal number corresponding to (N-K+j).

Manner 3: A $j^{th}$ information bit $a_j$ in the information bit sequence is set at a $g_j$ position in the initial information and frozen bit sequence, where j is any integer from 0 to K-1, and $g_j$ is a Gray code decimal number corresponding to j.

Manner 4: A $(K-1-j)^{th}$ information bit $a_{K-1-j}$ in the information bit sequence is set at a $g_j^{th}$ position in the initial information and frozen bit sequence, where j is any integer from 0 to K-1, and $g_j$ is a Gray code decimal number corresponding to j.

For example, in S220, determining a subchannel reliability value corresponding to each of the polarized subchannels according to the Gray mapping rule, a natural order subchannel index number, and a quantization weight value sequence includes at least one of the following steps S221 and S223.

At S221, a reliability value $w'_{g_i}$ of a $g_i^{th}$ polarized subchannel is calculated according to the quantization weight value sequence, where $g_i$ is a Gray code decimal number obtained by converting a natural order subchannel index number i according to the Gray mapping rule, the natural order subchannel index number i is any integer from 0 to N-1, the quantization weight value sequence includes n quantization weight values, and N is less than or equal to an $n^{th}$ power of 2.

For example, the reliability threshold $w'_{g_i}$ of the $g_i{}^{th}$ subchannel may be determined according to the following formula 4:

$$w'_{g_i} = \sum_{j=0}^{n-1} b_j \cdot \beta_j \quad \text{(Formula 4)}$$

where $w'_{g_i}$ represents the reliability threshold of the $g_i{}^{th}$ subchannel; $n = \log_2 N$, representing a number of bits required to express the integer N in a binary form; i represents a natural order subchannel index number, and $i \in \{0, 1, ..., N-1\}$; $g_i$ is a Grey code decimal number corresponding to i, where when expressed in a binary form, $g_i = b_{n-1}b_{n-2}...b_2b_1b_0$; $b_j$ represents a $j^{th}$ bit corresponding to the integer $g_i$ in the binary form; $\beta_j$ represents a $j^{th}$ quantization weight value in the quantization weight value sequence; and $j \in \{0, 1, ..., n-1\}$.

At S222, a reliability value $w'_{g_{i+1}}$ of a $g_{i+1}{}^{th}$ subchannel is calculated according to a reliability value $w'_{g_i}$ of a $g_i{}^{th}$ subchannel, where $g_i$ is a Gray code decimal number obtained by converting a natural order subchannel index number i according to the Gray mapping rule, the natural order subchannel index number i takes values in ascending order as 0, 1, 2, ..., N-1, the quantization weight value sequence includes n quantization weight values, and N is less than or equal to an $n^{th}$ power of 2.

It can be understood that a subchannel index number mapped to a natural order subchannel index number i-1 by Gray mapping is $g_{i-1}$, and when a reliability value $w'_{g_{i-1}}$ of the $g_{i-1}{}^{th}$ subchannel is known, the reliability value $w'_{g_i}$ of the $g_i{}^{th}$ subchannel can be calculated according to $w'_{g_{i-1}}$, where $g_0 = 0$, and $w'_{g_0} = 0$. Similarly, the reliability value $w'_{g_{i+1}}$ of the $g_{i+1}{}^{th}$ subchannel can be calculated according to $w'_{g_i}$. $w'_{g_i}$ is calculated based on the following formula 5.

$$w'_{g_i} = w'_{g_{i-1}} + \left(1 - 2 \cdot B_{e+1}\right) \cdot \beta_e \quad \text{(Formula 5)}$$

where i is expressed in binary form as $i = B_{n-1}B_{n-2}...B_2B_1B_0$; $B_j$ represents a $j^{th}$ bit corresponding to the integer i in the binary form and has a value of bit 0 or bit 1; $j \in \{0, 1, ..., n-1\}$; e is a position where a bit of 1 first appears starting from a $0^{th}$ bit $B_0$ of $B_{n-1}B_{n-2}...B_2B_1B_0$ (i.e., $B_e = 1$ and $B_{e-1} = B_{e-2} = ..., = B_0 = 0$); $B_e$ is a bit value of this position; $B_{e+1}$ is a bit value of an $(e+1)^{th}$ bit; $\beta_e$ is an $e^{th}$ element in the quantization weight value sequence $\beta$; and e E $\{0, 1, ..., n-1\}$.

At S223, a reliability value $w'_{g_i}$ of a $g_i{}^{th}$ subchannel is calculated according to a reliability value $w'_{g_{i+1}}$ of a $g_{i+i}{}^{th}$ subchannel, where $g_i$ is a Gray code decimal number obtained by converting a natural order subchannel index number i according to the Gray mapping rule, the natural order subchannel index number i takes values in descending order as N-1, N-2, N-3, ..., 0, the quantization weight value sequence includes n quantization weight values, and N is less than or equal to an $n^{th}$ power of 2.

It can be understood that a natural order subchannel index number i+1 is converted to a subchannel index number $g_{i+1}$ by Gray mapping, and the reliability value $w'_{g_i}$ of the $g_i{}^{th}$ subchannel is calculated according to the reliability value $w'_{g_{i+1}}$ of the $g_{i+i}{}^{th}$ subchannel, where $w'_{g_{N-1}}$ may be obtained according to S221. Similarly, a reliability value $w'_{g_{i-1}}$ of a $g_{i-1}{}^{th}$ subchannel can be calculated according to $w'_{g_i}$. $w'_{g_i}$ is calculated based on the following formula 6.

$$w'_{g_i} = w'_{g_{i+1}} - \left(1 - 2 \cdot B_{e+1}\right) \cdot \beta_e \quad \text{(Formula 6)}$$

where i+1 is expressed in binary form as $i+1 = B_{n-1}B_{n-2}...B_2B_1B_0$; $B_j$ represents a $j^{th}$ bit corresponding to the integer i+1 in the binary form and has a value of bit 0 or bit 1; $j \in \{0, 1, ..., n-1\}$; e is a position where a bit of 1 first appears starting from a $0^{th}$ bit $B_0$ of $B_{n-1}B_{n-2}...B_2B_1B_0$ (i.e., $B_e = 1$ and $B_{e-1} = B_{e-2} = ..., = B_0 = 0$); $B_e$ is a bit value of this position; $B_{e+1}$ is a bit value of an $(e+1)^{th}$ bit; $\beta_e$ is an $e^{th}$ element in the quantization weight value sequence $\beta$; and $e \in \{0, 1, ..., n-1\}$.

For example, in S230, determining an information and frozen bit indication corresponding to each of the polarized subchannels according to the subchannel reliability values corresponding to the polarized subchannels and a reliability threshold includes: when the subchannel reliability value corresponding to the polarized subchannel is greater than or equal to the reliability threshold, the information and frozen bit indication corresponding to the polarized subchannel is a first indication value, and the first indication value indicates that the polarized subchannel carries an information bit; and when the subchannel reliability value corresponding to the polarized subchannel is less than the reliability threshold, the information and frozen bit indication corresponding to the polarized subchannel is a second indication value, and the second indication value indicates that the polarized subchannel carries a frozen bit.

For example, the initial information and frozen bit sequence is expressed as $u = [u_0, u_1,..., u_{N-1}]$, and in S240, updating the initial information and frozen bit sequence according to the information and frozen bit indications corresponding to the polarized subchannel to obtain the information and frozen bit sequence may include:

traversing the natural order subchannel index numbers sequentially or in reverse order, and executing the following operations for the natural order subchannel index number i currently being traversed:

acquiring an information and frozen bit indication corresponding to a $g_i^{th}$ polarized subchannel;
adjusting a bit at a $g_i^{th}$ position in u to a $g_k^{th}$ position in u when the information and frozen bit indication corresponding to the $g_i^{th}$ polarized subchannel is a first indication value; or setting the bit at the $g_i^{th}$ position in u to 0 when the information and frozen bit indication corresponding to the $g_i^{th}$ polarized subchannel is a second indication value; and
obtaining the information and frozen bit sequence after the traversal of all the natural order subchannel index numbers is completed, where k represents an information bit index, k is any integer from 0 to K-1 or any integer from N-K to N, $g_i$ represents a Gray code decimal number corresponding to i, and $g_k$ represents a Gray code decimal number corresponding to k.

It should be noted that in the embodiments of the present disclosure, $\beta$ is used to represent the quantization weight value sequence, $\beta$ includes n quantization weight values, a $j^{th}$ quantization weight value in $\beta$ represents a quantization weight value corresponding to a $j^{th}$ bit in a binary expression of the subchannel index number, and j is any integer from 0 to n-1. For example, the subchannel index number $g_i$ is expressed in binary form as $g_i = b_{n-1}b_{n-2}...b_2b_1b_0$, where a $0^{th}$ bit $b_0$ is the lowest bit, and an $(n-1)^{th}$ bit $b_{n-1}$ is the highest bit, $\beta_j$ is the quantization weight value corresponding to $b_j$, $b_j$ represents a $j^{th}$ bit in the binary expression of the subchannel index number $g_i$, $j \in \{0, 1, ..., n\}$, $n = \log_2 N$, N is the number of polarized subchannels, and $g_i$ represents the Gray code decimal number corresponding to i.

It can be understood that n quantization weight values in the quantization weight value sequence are arranged in ascending order or descending order. When arranged in ascending order, the quantization weight value sequence $\beta$ may be expressed as: $\beta = [\beta_0, \beta_1, ..., \beta_{n-1}]$. When arranged in descending order, the quantization weight value sequence $\beta$ may be expressed as: $\beta = [\beta_{n-1}, \beta_{n-2}, ..., \beta_0]$.

It can be understood that a sum of all quantization weight values in the quantization weight value sequence $\beta$ is less than a first value. M is used to represent the first value, i.e., $\beta_{n-1}+\beta_{n-2}+...+\beta_0 < M$. It should be noted that M is a positive integer power of 2. For example, the first value includes one of: 256, 512, 1024, 2048, or 4096.

It can be understood that the quantization weight value sequence may be determined in one of the following two manners.

In a first manner, the quantization weight value sequence may be preset, and the preset quantization weight value sequence $\beta = [\beta_{n-1}, \beta_{n-2}, ..., \beta_0]$ satisfies $\beta_{n-1}+\beta_{n-2}+...+\beta_0 < M$, where M is a positive integer power of 2.

In a second manner, the quantization weight value sequence is determined according to a constraint condition that a number of differences between a quantized polar weight sequence (quantized PW sequence) obtained by the quantization weight value sequence and a polar weight sequence (PW sequence) is not greater than a second value D. The second value D is an integer greater than or equal to 0 and less than or equal to N. It is assumed that $M = 2^1$, 1 being a positive integer. When $M = 2^1$, each reliability threshold only needs 1 bit for storage. The element $\beta_j$ in $\beta$ is a positive integer, $j \in \{0, 1, ..., n\}$, $n = \log_2 N$, and D is an integer greater than or equal to 0 and less than or equal to N.

For example, the quantization weight value sequence $\beta$ includes one of:

$$\beta = [96, 81, 68, 57, 48, 40, 34, 28, 24, 20];$$

$$\beta = [197, 165, 139, 116, 98, 82, 68, 58, 49, 41];$$

$$\beta = [389, 327, 275, 231, 194, 163, 137, 115, 97, 82];$$

$$\beta = [780, 656, 552, 464, 390, 328, 276, 232, 195, 164];$$

$$\beta = [51, 43, 36, 30, 25, 21, 18, 15, 13];$$

$$\beta = [101, 85, 71, 60, 50, 42, 35, 30, 25];$$

$$\beta = [206, 173, 145, 122, 102, 86, 73, 61, 51];$$

$$\beta = [480, 404, 340, 286, 240, 202, 170, 143, 120].$$

For example, the reliability threshold in the embodiments of the present disclosure may be obtained from a preset mapping relationship according to an index value. The index value is determined according to at least one of the number K of information bits, the number N of polarized subchannels, and a code rate R. The mapping relationship includes, but not limited to, at least one of: a mapping formula, a mapping table, or a mapping graph. Of course, the mapping relationship may also be other expressions indicating a correspondence, which is not limited in the embodiments of the present disclosure.

In a possible implementation, for the information bit sequence $a = [a_0, a_1,..., a_{k-1}]$, the natural order subchannel index number i is converted to the subchannel index number $g_i$ by Gray mapping, the reliability value of the $g_i{}^{th}$ subchannel may be calculated according to the quantization weight value sequence, the reliability threshold may be obtained according to the mapping relationship, and it can be determined whether the $g_i{}^{th}$ subchannel carries information bits by comparing the reliability value of the $g_i{}^{th}$ subchannel with the reliability threshold. Thus, the information and frozen bit sequence $u = [u_0, u_1,..., u_{N-1}]$ can be determined, and then the information and frozen bit sequence u is encoded to obtain encoded data $d = [d_0, d_1, ..., d_{N-1}]$.

It can be understood that the information bit sequence and the information and frozen bit sequence satisfy the following mapping relationship: $u_{f1(j)} = a_{f2(j)}$, where f1 is a function of j, and is determined according to, for example, but not limited to, f2(j), a Gray map, an information and frozen bit indication, and an information index number, and $f1(j) \in \{0, 1, ..., N-1\}$; f2 is a function of j, including, but not limited to, f(j)=j and f(j)=K-j; $f2(j) \in \{0, 1, ..., K-1\}$; and j = 0, 1, ..., K-1. Based on the above mapping relationship, elements in the information and frozen bit sequence $u = [u_0, u_1,..., u_{N-1}]$ can be determined according to the obtained information bit sequence $a = [a_0, a_1, ..., a_{k-1}]$.

For example, the natural order subchannel index number takes values in ascending order as 0, 1, 2, ..., N-1; or the natural order subchannel index number takes values in descending order as N-1, N-2, N-3, ..., 0.

For example, the subchannel index numbers corresponding to the N polarized subchannels may be arranged in descending order or in ascending order to obtain a natural order subchannel index number sequence [0, 1, ..., N-1] or [N-1, N-2, ..., 0]. Then, the natural order subchannel index numbers in the natural order subchannel index number sequence are traversed. For each natural order subchannel index number i being traversed, a reliability value and an information and frozen bit indication of a subchannel having a subchannel index number $g_i$ corresponding to the natural order subchannel index number i are determined, then it is determined according to the information and frozen bit indication whether bits carried by the $g_i{}^{th}$ polarized subchannel currently being traversed are information bits or frozen bits, and the information and frozen bit sequence is updated. When the traversal of the N polarized subchannels is completed, a final information and frozen bit sequence is obtained.

For example, encoding the information and frozen bit sequence to obtain an encoded data sequence includes: acquiring an n-stage serial encoder, where the n-stage serial encoder is configured for performing n-stage serial encoding, and in each stage of serial encoding, bits in the information and frozen bit sequence are encoded in groups of two; and encoding the information and frozen bit sequence by using the n-stage serial encoder to obtain the encoded data sequence.

The data processing method provided in the embodiments of the present disclosure will be described in detail below through specific examples.

Example One

An inputted information bit sequence a ($a = [a_0, a_1, ..., a_{k-1}]$) is initialized based on a Gray mapping rule to obtain an initial information and frozen bit sequence u ($u = [u_0, u_1, ..., u_{N-1}]$). The initial information and frozen bit sequence u satisfy one of: $[u_{g_r}, u_{g_{r+1}}, u_{g_{r+2}}, ..., u_{g_{r+K-1}}] = [a_0, a_1, ..., a_{K-1}]$ or $[u_{g_r}, u_{g_{r+1}} u_{g_{r+2}}, ..., u_{g_{r+K-1}}] = [a_{k-1}, a_{K-2}, a_{K-3}, ..., a_0]$, where r = 0, 1, 2, ..., N-K.

For example, information bits in the information bit sequence a are set in the initial information and frozen bit sequence u in any of the following manners.

Manner 1: When r = N-K, the initial information and frozen bit sequence u satisfies $[u_{g_r}, u_{g_{r+1}} u_{g_{r+2}}, ..., u_{g_{r+K-1}}] = [a_0, a_1, ..., a_{k-1}]$, indicating that a $j^{th}$ information bit $a_j$ in the information bit sequence is set at a $g_{N-K+j}{}^{th}$ position in the initial information and frozen bit sequence, where j is any integer from 0 to K-1, and $g_{N-K+j}$ represents a Gray code decimal number corresponding to (N-K+j). In a feasible embodiment, a result of Manner 1 may be obtained by performing the following two steps.

At step one, the information bits in the information bit sequence are sequentially set at the last K bits of the initial information and frozen bit sequence. It can be understood that when the information bits in the information bit sequence a = $[a_0, a_1, ..., a_{k-1}]$ are sequentially set at the last K bits of the information and frozen bit sequence, u = $[u_0, u_1, ..., u_{N-1}]$ = $[0, ..., 0, a_0, a_1, ..., a_{k-1}]$ is obtained, where N represents the number of polarized subchannels and has a value which is a positive integer power of 2, K represents the number of information bits and has a value which is a positive integer, and K < N.

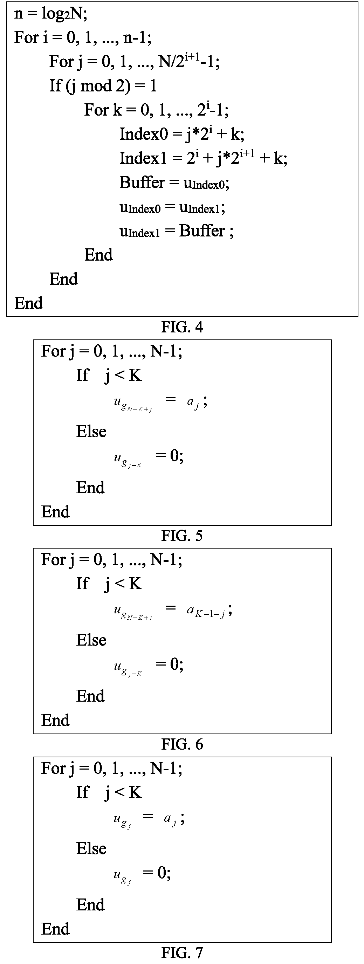

At step two, the initial information and frozen bit sequence u = $[u_0, u_1, ..., u_{N-1}]$ = $[0, ..., 0, a_0, a_1, ..., a_{k-1}]$ is updated according to Gray mapping, including: adjusting an element $u_i$ at an $i^{th}$ position in u before update to a $g_i^{th}$ position, where $g_i$ is a Gray code decimal number corresponding to i. For example, the updating process for adjusting the element $u_i$ at the $i^{th}$ position to the $g_i^{th}$ position may be implemented by a logic code shown in FIG. 4.

In a feasible embodiment, the result of Manner 1 may also be obtained by performing the following operations: storing the information bit sequence a = $[a_0, a_1, ..., a_{k-1}]$ using a K-bit buffer, and adjusting the $j^{th}$ element $a_j$ in a to the $g_{N-K+j}^{th}$ position of the information and frozen bit sequence u. The initialization process of the information and frozen bit sequence u may be implemented by a logic code shown in FIG. 5.

Manner 2: When r = N-K, the initial information and frozen bit sequence u satisfies $[u_{gr}, u_{gr+1}\, u_{gr+2}, ..., u_{gr+K-1}]$ = $[a_{K-1}, a_{K-2}, a_{K-3}, ..., a_0]$, indicating that a $(K-1-j)^{th}$ information bit $a_{K-1-j}$ in the information bit sequence is set at a $g_{N-K+j}^{th}$ position in the initial information and frozen bit sequence, where j is any integer from 0 to K-1, and $g_{N-K+j}$ represents a Gray code decimal number corresponding to (N-K+j). In a feasible embodiment, a result of Manner 2 may be obtained by performing the following two steps.

At step one, the information bits in the information bit sequence are set in reverse order at the last K bits of the initial information and frozen bit sequence. It can be understood that when the information bits in the information bit sequence a = $[a_0, a_1, ..., a_{k-1}]$ are set in reverse order at the last K bits of the initial information and frozen bit sequence, an initial information and frozen bit sequence u = $[u_0, u_1, ..., u_{N-1}]$ = $[0, ..., 0, a_{K-1}, a_{K-2}, ..., a_0]$ is obtained, where N represents the number of polarized subchannels and has a value which is a positive integer power of 2, K represents the number of information bits and has a value which is a positive integer, and K < N.

At step two, the initial information and frozen bit sequence u = $[u_0, u_1, ..., u_{N-1}]$ = $[0, ..., 0, a_{K-1}, a_{K-2}, ..., a_0]$ is updated according to Gray mapping, including: adjusting an element $u_i$ at an $i^{th}$ position in u before update to a $g_i^{th}$ position, where $g_i$ is a Gray code decimal number corresponding to i. For example, the updating process for adjusting the element $u_i$ at the $i^{th}$ position to the $g_i^{th}$ position may be implemented by a logic code shown in FIG. 4.

In a feasible embodiment, the result of Manner 2 may also be obtained by performing the following operations: storing the information bit sequence a = $[a_0, a_1, ..., a_{k-1}]$ using a K-bit buffer, and adjusting the $(K-1-j)^{th}$ element $a_{K-1-j}$ in a to the $g_{N-K+j}^{th}$ position of the information and frozen bit sequence u. The initialization process of the information and frozen bit sequence u may be implemented by a logic code shown in FIG. 6.

Manner 3: When r = 0, the initial information and frozen bit sequence u satisfies $[u_{gr}, u_{gr+1}, u_{gr+2}, ..., u_{gr+K-1}]$ = $[a_0, a_1, ..., a_{K-1}]$, indicating that a $j^{th}$ information bit $a_j$ in the information bit sequence is set at a $g_j^{th}$ position in the initial information and frozen bit sequence, where j is any integer from 0 to K-1, and $g_j$ is a Gray code decimal number corresponding to j. In a feasible embodiment, a result of Manner 3 may be obtained by performing the following two steps.

At step one, the information bits in the information bit sequence are sequentially set at the first K bits of the initial information and frozen bit sequence. It can be understood that when the information bits in the information bit sequence a = $[a_0, a_1, ..., a_{k-1}]$ are sequentially set at the first K bits of the information and frozen bit sequence, an initial information and frozen bit sequence u = $[u_0, u_1, ..., u_{N-1}]$ = $[a_0, a_1, ..., a_{k-1}, 0, ..., 0]$ is obtained, where N represents the number of polarized subchannels and has a value which is a positive integer power of 2, K represents the number of information bits and has a value which is a positive integer, and K < N.

At step two, the initial information and frozen bit sequence u = $[u_0, u_1, ..., u_{N-1}]$ = $[a_0, a_1, ..., a_{k-1}, 0, ..., 0]$ is updated according to Gray mapping, including: adjusting an element $u_i$ at an $i^{th}$ position in u before update to a $g_i^{th}$ position, where $g_i$ is a Gray code decimal number corresponding to i. For example, the updating process for adjusting the element $u_i$ at the $i^{th}$ position to the $g_i^{th}$ position may be implemented by a logic code shown in FIG. 4.

In a feasible embodiment, the result of Manner 3 may also be obtained by performing the following operations: storing the information bit sequence a = $[a_0, a_1, ..., a_{k-1}]$ using a K-bit buffer, and adjusting the $j^{th}$ element $a_j$ in a to the $g_j^{th}$ position of the information and frozen bit sequence u. The initialization process of the information and frozen bit sequence u may be implemented by a logic code shown in FIG. 7.

Manner 4: When r = 0, the initial information and frozen bit sequence u satisfies $[u_{gr}, u_{gr+1}\, u_{gr+2}, ..., u_{gr+K-1}]$ = $[a_{K-1}, a_{K-2}, a_{K-3}, ..., a_0]$, indicating that a $(K-1-j)^{th}$ information bit $a_{K-1-j}$ in the information bit sequence is set at a $g_j^{th}$ position in the initial information and frozen bit sequence, where j is any integer from 0 to K-1, and $g_i$ is a Gray code decimal number corresponding to j. In a feasible embodiment, a result of Manner 4 may be obtained by performing the following two steps.

At step one, the information bits in the information bit sequence are set in reverse order at the first K bits of the initial information and frozen bit sequence. It can be understood that when the information bits in the information bit sequence a = $[a_0, a_1, ..., a_{k-1}]$ are set in reverse order at the first K bits of the information and frozen bit sequence, an initial information and frozen bit sequence u = [$u_0$, $u_1$, ..., $u_{N-1}$] =[$a_{K-1}$, $a_{K-2}$, ..., $a_0$, 0, ..., 0] is obtained, where N represents the number of polarized subchannels and has a value which is a positive integer power of 2, K represents the number of information bits and has a value which is a positive integer, and K < N.

At step two, the initial information and frozen bit sequence u = [$u_0$, $u_1$, ..., $u_{N-1}$] = [$a_{K-1}$, $a_{K-2}$, ..., $a_0$, 0, ..., 0] is updated according to Gray mapping, including: adjusting an element $u_i$ at an $i^{th}$ position in u before update to a $g_i^{th}$ position, where $g_i$ is a Gray code decimal number corresponding to i. For example, the updating process for adjusting the element $u_i$ at the $i^{th}$ position to the $g_i^{th}$ position may be implemented by a logic code shown in FIG. 4.

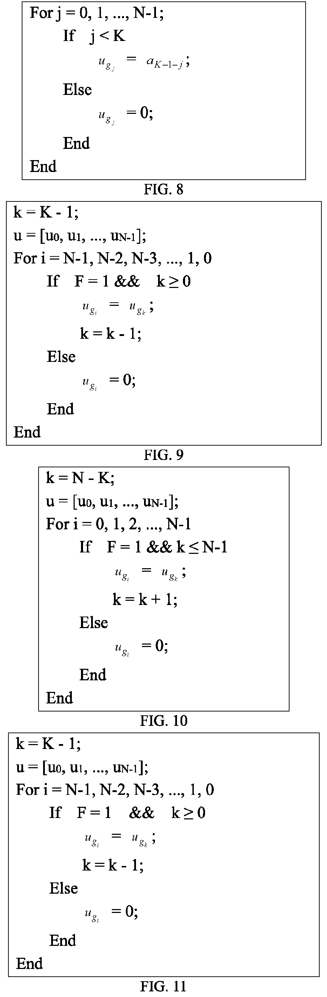

In a feasible embodiment, the result of Manner 4 may also be obtained by performing the following operations: storing the information bit sequence a = [$a_0$, $a_1$, ..., $a_{k-1}$] using a K-bit buffer, and adjusting the $(K-1-j)^{th}$ element $a_{K-1-j}$ in a to the $g_j^{th}$ position of the information and frozen bit sequence u. The initialization process of the information and frozen bit sequence u may be implemented by a logic code shown in FIG. 8.

It can be understood that when the information bit sequence is initially stored in the information and frozen bit sequence according to the above rules, the reliability value of the current subchannel can be easily calculated according to the reliability value of the previous subchannel by means of the information index number and the information and frozen bit indication during the calculation of the reliability value of the $g_i^{th}$ subchannel, thereby saving computing resources.

Example Two

A reliability threshold $w_{th}$ is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a mapping table (hereinafter referred to as a reliability threshold table).

For example, N is a positive integer power of 2, including, but not limited to, one of: 32, 64, 128, 256, 512, or 1024; K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299; $w_{K,N}$<M, M is a positive integer power of 2, and a value of M includes, but not limited to, one of: 256, 512, 1024, 2048, or 4096. Table 3 is a feasible reliability threshold table indexed by K and N. In some other examples, the reliability threshold table includes at least one row or at least one column in Table 3. It can be understood that Table 3 is merely a feasible mapping form of the reliability threshold table, and the reliability threshold table may also be in other mapping forms, which is not particularly limited in the embodiments of the present disclosure.

Table 3 Reliability threshold table indexed by K and N

| K / N | 32 | 64 | 128 | 256 | 512 | 1024 |
|---|---|---|---|---|---|---|
| 25 | $w_{25,32}$ | $w_{25,64}$ | $w_{25,128}$ | $w_{25,256}$ | $w_{25,512}$ | $w_{25,1024}$ |
| 35 | NaN | $w_{35,64}$ | $w_{35,128}$ | $w_{35,256}$ | $w_{35,512}$ | $w_{35,1024}$ |
| 43 | NaN | $w_{43,64}$ | $w_{43,128}$ | $w_{43,256}$ | $w_{43,512}$ | $w_{43,1024}$ |
| 51 | NaN | $w_{51,64}$ | $w_{51,128}$ | $w_{51,256}$ | $w_{51,512}$ | $w_{51,1024}$ |
| 59 | NaN | $w_{59,64}$ | $w_{59,128}$ | $w_{59,256}$ | $w_{59,512}$ | $w_{59,1024}$ |
| 67 | NaN | NaN | $w_{67,128}$ | $w_{67,256}$ | $w_{67,512}$ | $w_{67,1024}$ |
| 75 | NaN | NaN | $w_{75,128}$ | $w_{75,256}$ | $w_{75,512}$ | $w_{75,1024}$ |
| 83 | NaN | NaN | $w_{83,128}$ | $w_{83,256}$ | $w_{83,512}$ | $w_{83,1024}$ |
| 91 | NaN | NaN | $w_{91,128}$ | $w_{91,256}$ | $w_{91,512}$ | $w_{91,1024}$ |
| 99 | NaN | NaN | $w_{99,128}$ | $w_{99,256}$ | $w_{99,512}$ | $w_{99,1024}$ |
| 107 | NaN | NaN | $w_{107,128}$ | $w_{107,256}$ | $w_{107,512}$ | $w_{107,1024}$ |
| 115 | NaN | NaN | $w_{115,128}$ | $w_{115,256}$ | $w_{115,512}$ | $w_{115,1024}$ |
| 123 | NaN | NaN | $w_{123,128}$ | $w_{123,256}$ | $w_{123,512}$ | $w_{123,1024}$ |
| 131 | NaN | NaN | NaN | $w_{131,256}$ | $w_{131,512}$ | $w_{131,1024}$ |
| 139 | NaN | NaN | NaN | $w_{139,256}$ | $w_{139,512}$ | $w_{139,1024}$ |
| 147 | NaN | NaN | NaN | $w_{147,256}$ | $w_{147,512}$ | $w_{147,1024}$ |

(continued)

| K / N | 32 | 64 | 128 | 256 | 512 | 1024 |
|---|---|---|---|---|---|---|
| 155 | NaN | NaN | NaN | $w_{155,256}$ | $w_{155,512}$ | $w_{155,1024}$ |
| 163 | NaN | NaN | NaN | $w_{163,256}$ | $w_{163,512}$ | $w_{163,1024}$ |
| 171 | NaN | NaN | NaN | $w_{171,256}$ | $w_{171,512}$ | $w_{171,1024}$ |
| 179 | NaN | NaN | NaN | $w_{179,256}$ | $w_{179,512}$ | $w_{179,1024}$ |
| 187 | NaN | NaN | NaN | $w_{187,256}$ | $w_{187,512}$ | $w_{187,1024}$ |
| 195 | NaN | NaN | NaN | $w_{195,256}$ | $w_{195,512}$ | $w_{195,1024}$ |
| 203 | NaN | NaN | NaN | $w_{203,256}$ | $w_{203,512}$ | $w_{203,1024}$ |
| 219 | NaN | NaN | NaN | $w_{219,256}$ | $w_{219,512}$ | $w_{219,1024}$ |
| 235 | NaN | NaN | NaN | $w_{235,256}$ | $w_{235,512}$ | $w_{235,1024}$ |
| 251 | NaN | NaN | NaN | $w_{251,256}$ | $w_{251,512}$ | $w_{251,1024}$ |
| 267 | NaN | NaN | NaN | NaN | $w_{267,512}$ | $w_{267,1024}$ |
| 283 | NaN | NaN | NaN | NaN | $w_{283,512}$ | $w_{283,1024}$ |
| 299 | NaN | NaN | NaN | NaN | $w_{299,512}$ | $w_{299,1024}$ |

It can be understood that the relationship between the reliability threshold and the number K of information bits and the relationship between the reliability threshold and the number N of polarized subchannels can be obtained from the reliability threshold table, and a reliability threshold corresponding to a combination of a value of K and a value of N includes one of: NaN and $w_{K,N}$, where "NaN" is a null value, indicating that there is no reliability threshold corresponding to the current combination of K and N, and $w_{K,N}$ is a reliability threshold corresponding to the combination of K and N.

It can be understood that when the value of K is greater than or equal to the value of N, the reliability threshold corresponding to the value of K and the value of N is NaN, where NaN indicates that the reliability threshold is a null value.

It can also be understood that when the value of K is less than the value of N, the reliability threshold corresponding to the value of K and the value of N is $w_{K,N}$. In a feasible implementation, a value of $w_{K,N}$ is determined by performing the following steps S610 to S613.

At S610, a subchannel reliability value corresponding to each of the polarized subchannels is calculated according to the quantization weight value sequence β and the subchannel index numbers i respectively corresponding to the polarized subchannels.

At S611, a subchannel reliability sequence is obtained according to the subchannel reliability values corresponding to the N polarized subchannels.

At S612, K largest subchannel reliability values are selected from the subchannel reliability sequence.

At S613, the smallest subchannel reliability value is selected as $w_{K,N}$ from the K largest subchannel reliability values.

In other words, N subchannel reliability values $w' = [w'_0, w'_1, ..., w'_{N-1}]$ are calculated according to the quantization weight value sequence β and the subchannel index number i; and K largest reliability values are selected from w', and then the smallest value $w_{N-K}$ is selected from the K largest reliability values, where $w_{N-K}$ is an element value at a position (N, K) in the reliability threshold table.

For example, the reliability threshold $w'_i$ of the $i^{th}$ subchannel is determined according to the following formula 7:

$$w'_i = \sum_{j=0}^{n-1} B_j \cdot \beta_j \quad \text{(Formula 7)}$$

where $n = \log_2 N$ represents a number of bits required to express the integer N in a binary form; i is an integer greater than or equal to 0 and less than N, i is expressed in binary form, and $i = B_{n-1}B_{n-2}...B_2B_1B_0$; and $B_j$ represents a $j^{th}$ bit corresponding to the integer i in the binary form.

It can be understood that any value of N corresponds to K1 and K2. K1 and K2 represent two different values of K. When K1 is less than K2, $w_{K1,N}$ is greater than $w_{K2,N}$, $w_{K1,N}$ represents a reliability threshold corresponding to the value of K1 and the value of N, and $w_{K2,N}$ represents a reliability threshold corresponding to the value of K2 and the value of N.

Any value of K corresponds to N1 and N2. N1 and N2 represent two different values of N. When N1 is less than N2,

$w_{K,N1}$ is less than $w_{K,N2}$, $w_{K,N1}$ represents a reliability threshold corresponding to the value of K and the value of N1, and $w_{K,N2}$ represents a reliability threshold corresponding to the value of K and the value of N2.

Example Three

A reliability threshold $w_{th}$ is obtained from a preset mapping relationship according to an index value. In this example, the index value is determined according to a value of a number K of information bits and a value of a code rate R, and a mapping relationship between the number K of information bits, the code rate R, and the reliability threshold is recorded through a mapping table (hereinafter referred to as a reliability threshold table).

For example, R is a real number greater than 0 and less than 1, including, but not limited to, one of: 25/32, 25/64, 25/128, 25/256, 25/512, 25/1024, 35/64, 35/128, 35/256, 35/512, 35/1024, 43/64, 43/128, 43/256, 43/512, 43/1024, 51/64, 51/128, 51/256, 51/512, 51/1024, 59/64, 59/128, 59/256, 59/512, or 59/1024; K is a positive integer, including, but not limited to, one of: 25, 35, 43, 51, or 59; and $w_{K,R}<M$, M is a positive integer power of 2, and a value of M includes, but not limited to, one of: 256, 512, 1024, 2048, or 4096. A reliability threshold table indexed by K and R is shown in Table 4. In some other examples, the reliability threshold table includes at least one row or at least one column in Table 4. It can be understood that Table 4 is merely a feasible mapping form of the reliability threshold table, and the reliability threshold table may also be in other mapping forms, which is not particularly limited in the embodiments of the present disclosure.

Table 4 Reliability threshold table indexed by K and R

| K=25 | R | 25/32 | 25/64 | 25/128 | 25/256 | 25/512 | 25/1024 |
|---|---|---|---|---|---|---|---|
| | $w_{K,R}$ | $w_{25,25/32}$ | $w_{25,25/64}$ | $w_{25,25/128}$ | $w_{25,25/256}$ | $w_{25,25/512}$ | $w_{25,25/1024}$ |
| K=35 | R | 35/32 | 35/64 | 35/128 | 35/256 | 35/512 | 35/1024 |
| | $w_{K,R}$ | NaN | $w_{35,35/64}$ | $w_{35,35/128}$ | $w_{35,35/256}$ | $w_{35,35/512}$ | $w_{35,35/1024}$ |
| K=43 | R | 43/32 | 43/64 | 43/128 | 43/256 | 43/512 | 43/1024 |
| | $w_{K,R}$ | NaN | $w_{43,43/64}$ | $w_{43,43/128}$ | $w_{43,43/256}$ | $w_{43,43/512}$ | $w_{43,43/1024}$ |
| K=51 | R | 51/32 | 51/64 | 51/128 | 51/256 | 51/512 | 51/1024 |
| | $w_{K,R}$ | NaN | $w_{51,51/64}$ | $w_{51,51/128}$ | $w_{51,51/256}$ | $w_{51,51/512}$ | $w_{51,51/1024}$ |
| K=59 | R | 59/32 | 59/64 | 59/128 | 59/256 | 59/512 | 59/1024 |
| | 59 | NaN | $w_{59,59/64}$ | $w_{59,59/128}$ | $w_{59,59/256}$ | $w_{59,59/512}$ | $w_{59,59/1024}$ |

It can be understood that the relationship between the reliability threshold and the number K of information bits and the relationship between the reliability threshold and the code rate R can be obtained from the reliability threshold table. A reliability threshold corresponding to a combination of a value of K and a value of N includes one of: NaN and $w_{K,R}$, where "NaN" is a null value, indicating that there is no reliability threshold corresponding to the current combination of K and R, and $w_{K,R}$ is a reliability threshold corresponding to the combination of K and R.

It is understood that when K is equal to or greater than K/R, the reliability threshold corresponding to the value of K and the value of R is NaN, where NaN indicates that the reliability threshold is a null value.

It can also be understood that when K is less than K/R, the reliability threshold corresponding to the value of K and the value of R is $w_{K,R}$. In a feasible implementation, a value of $w_{K,R}$ is determined by performing the following steps S620 to S623.

At S620, a value of N is determined according to a value of K and a value of R.

At S621, a subchannel reliability value corresponding to each of the polarized subchannels is calculated according to the quantization weight value sequence β and the subchannel index numbers i respectively corresponding to the N polarized subchannels.

At S622, a subchannel reliability sequence is obtained according to the subchannel reliability values corresponding to the N polarized subchannels, and K largest subchannel reliability values are selected from the subchannel reliability sequence.

At S623, the smallest subchannel reliability value is selected as $w_{K,R}$ from the K largest subchannel reliability values.

In other words, first, a number N of polarized subchannels is determined according to the number K of information bits and the code rate R. For example, N = K/R; then, N subchannel reliability values w' = $[w'_0, w'_1, ..., w'_{N-1}]$ are calculated according to the quantization weight value sequence β and the subchannel index number i; and K largest reliability values are selected from w', and then the smallest value $w_{N-K}$ is selected from the K largest reliability values, where $w_{N-K}$ is an element value at a position (R, K) in the reliability threshold table.

It can be understood that any value of K corresponds to R1 and R2. R1 and R2 represent two different values of R. When R1 is less than R2, $w_{K,R1}$ is greater than $w_{K,R2}$, $w_{K,R1}$ represents a reliability threshold corresponding to the value of K and the value of R1, and $w_{K,R2}$ represents a reliability threshold corresponding to the value of K and the value of R2.

It can be understood that any value of K corresponds to R1 and R2. R1 and R2 represent two different values of R. When R1 is less than R2, $w_{K,R1}$ is greater than $w_{K,R2}$, $w_{K,R1}$ represents a reliability threshold corresponding to the value of K and the value of R1, and $w_{K,R2}$ represents a reliability threshold corresponding to the value of K and the value of R2.

Example Four

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence β.

For example, the quantization weight value sequence is $\beta = [\beta_{n-1}, \beta_{n-2}, ..., \beta_0] = [96, 81, 68, 57, 48, 40, 34, 28, 24, 20]$, and n = 10; N is a positive integer power of 2, including, but not limited to, one of: 32, 64, 128, 256, 512, or 1024; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 5 provides a specific example of the reliability threshold table. In another example, the reliability threshold table includes at least one row or at least one column in Table 5.

Table 5 Reliability threshold table when β = [96, 81, 68, 57, 48, 40, 34, 28, 24, 20]

| K / N | 32 | 64 | 128 | 256 | 512 | 1024 |
|---|---|---|---|---|---|---|
| 25 | 48 | 110 | 170 | 241 | 322 | 418 |
| 35 | NaN | 92 | 159 | 228 | 312 | 408 |
| 43 | NaN | 78 | 149 | 221 | 303 | 400 |
| 51 | NaN | 62 | 140 | 213 | 295 | 394 |
| 59 | NaN | 40 | 131 | 207 | 291 | 387 |
| 67 | NaN | NaN | 122 | 200 | 284 | 381 |
| 75 | NaN | NaN | 115 | 194 | 279 | 376 |
| 83 | NaN | NaN | 106 | 189 | 275 | 372 |
| 91 | NaN | NaN | 97 | 183 | 271 | 368 |
| 99 | NaN | NaN | 86 | 178 | 266 | 365 |
| 107 | NaN | NaN | 76 | 173 | 261 | 360 |
| 115 | NaN | NaN | 60 | 169 | 258 | 356 |
| 123 | NaN | NaN | 40 | 163 | 254 | 353 |
| 131 | NaN | NaN | NaN | 159 | 251 | 351 |
| 139 | NaN | NaN | NaN | 153 | 247 | 347 |
| 147 | NaN | NaN | NaN | 149 | 243 | 344 |
| 155 | NaN | NaN | NaN | 143 | 240 | 342 |
| 163 | NaN | NaN | NaN | 139 | 236 | 338 |
| 171 | NaN | NaN | NaN | 132 | 233 | 336 |
| 179 | NaN | NaN | NaN | 126 | 230 | 332 |
| 187 | NaN | NaN | NaN | 121 | 227 | 330 |
| 195 | NaN | NaN | NaN | 116 | 223 | 327 |
| 203 | NaN | NaN | NaN | 108 | 221 | 326 |

(continued)

| K N | 32 | 64 | 128 | 256 | 512 | 1024 |
|---|---|---|---|---|---|---|
| 219 | NaN | NaN | NaN | 92 | 214 | 320 |
| 235 | NaN | NaN | NaN | 74 | 207 | 316 |
| 251 | NaN | NaN | NaN | 40 | 202 | 311 |
| 267 | NaN | NaN | NaN | NaN | 197 | 307 |
| 283 | NaN | NaN | NaN | NaN | 190 | 303 |
| 299 | NaN | NaN | NaN | NaN | 183 | 298 |

Example Five

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [197, 165, 139, 116, 98, 82, 68, 58, 49, 41]$, and n = 10; N is a positive integer power of 2, including, but not limited to, one of: 32, 64, 128, 256, 512, or 1024; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 6 provides a specific example of the reliability threshold table. In another example, the reliability threshold table includes at least one row or at least one column in Table 6.

Table 6 Reliability threshold table when $\beta = [197, 165, 139, 116, 98, 82, 68, 58, 49, 41]$

| K N | 32 | 64 | 128 | 256 | 512 | 1024 |
|---|---|---|---|---|---|---|
| 25 | 99 | 224 | 347 | 493 | 658 | 855 |
| 35 | NaN | 189 | 323 | 467 | 635 | 832 |
| 43 | NaN | 158 | 304 | 452 | 618 | 816 |
| 51 | NaN | 126 | 287 | 436 | 602 | 805 |
| 59 | NaN | 82 | 266 | 422 | 593 | 790 |
| 67 | NaN | NaN | 249 | 409 | 579 | 780 |
| 75 | NaN | NaN | 233 | 396 | 569 | 767 |
| 83 | NaN | NaN | 215 | 386 | 560 | 758 |
| 91 | NaN | NaN | 198 | 373 | 552 | 751 |
| 99 | NaN | NaN | 175 | 363 | 543 | 747 |
| 107 | NaN | NaN | 156 | 354 | 534 | 735 |
| 115 | NaN | NaN | 123 | 345 | 527 | 727 |
| 123 | NaN | NaN | 82 | 332 | 519 | 722 |
| 131 | NaN | NaN | NaN | 323 | 511 | 716 |
| 139 | NaN | NaN | NaN | 313 | 503 | 709 |
| 147 | NaN | NaN | NaN | 304 | 495 | 702 |
| 155 | NaN | NaN | NaN | 291 | 488 | 699 |
| 163 | NaN | NaN | NaN | 282 | 480 | 691 |
| 171 | NaN | NaN | NaN | 270 | 476 | 685 |

(continued)

| K / N | 32 | 64 | 128 | 256 | 512 | 1024 |
|---|---|---|---|---|---|---|
| 179 | NaN | NaN | NaN | 256 | 470 | 677 |
| 187 | NaN | NaN | NaN | 247 | 462 | 675 |
| 195 | NaN | NaN | NaN | 237 | 454 | 668 |
| 203 | NaN | NaN | NaN | 221 | 452 | 666 |
| 219 | NaN | NaN | NaN | 189 | 436 | 653 |
| 235 | NaN | NaN | NaN | 150 | 422 | 644 |
| 251 | NaN | NaN | NaN | 82 | 412 | 635 |
| 267 | NaN | NaN | NaN | NaN | 402 | 627 |
| 283 | NaN | NaN | NaN | NaN | 388 | 618 |
| 299 | NaN | NaN | NaN | NaN | 373 | 609 |

Example Six

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [389, 327, 275, 231, 194, 163, 137, 115, 97, 82]$, and $n = 10$; N is a positive integer power of 2, including, but not limited to, one of: 32, 64, 128, 256, 512, or 1024; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 7 provides a specific example of the reliability threshold table. In another example, the reliability threshold table includes at least one row or at least one column in Table 7.

Table 7 Reliability threshold table when $\beta = [389, 327, 275, 231, 194, 163, 137, 115, 97, 82]$

| K / N | 32 | 64 | 128 | 256 | 512 | 1024 |
|---|---|---|---|---|---|---|
| 25 | 197 | 446 | 691 | 978 | 1305 | 1694 |
| 35 | NaN | 375 | 644 | 926 | 1261 | 1650 |
| 43 | NaN | 316 | 604 | 897 | 1227 | 1619 |
| 51 | NaN | 252 | 569 | 866 | 1197 | 1595 |
| 59 | NaN | 163 | 531 | 840 | 1178 | 1568 |
| 67 | NaN | NaN | 497 | 811 | 1152 | 1545 |
| 75 | NaN | NaN | 465 | 787 | 1131 | 1524 |
| 83 | NaN | NaN | 428 | 767 | 1112 | 1506 |
| 91 | NaN | NaN | 394 | 743 | 1096 | 1490 |
| 99 | NaN | NaN | 349 | 721 | 1078 | 1479 |
| 107 | NaN | NaN | 309 | 703 | 1059 | 1459 |
| 115 | NaN | NaN | 245 | 685 | 1045 | 1444 |
| 123 | NaN | NaN | 163 | 662 | 1030 | 1431 |
| 131 | NaN | NaN | NaN | 643 | 1015 | 1419 |
| 139 | NaN | NaN | NaN | 621 | 1000 | 1406 |

(continued)

| K N | 32 | 64 | 128 | 256 | 512 | 1024 |
|---|---|---|---|---|---|---|
| 147 | NaN | NaN | NaN | 603 | 985 | 1393 |
| 155 | NaN | NaN | NaN | 580 | 971 | 1385 |
| 163 | NaN | NaN | NaN | 562 | 955 | 1370 |
| 171 | NaN | NaN | NaN | 535 | 944 | 1360 |
| 179 | NaN | NaN | NaN | 510 | 933 | 1346 |
| 187 | NaN | NaN | NaN | 491 | 918 | 1337 |
| 195 | NaN | NaN | NaN | 469 | 904 | 1326 |
| 203 | NaN | NaN | NaN | 439 | 896 | 1319 |
| 219 | NaN | NaN | NaN | 375 | 866 | 1296 |
| 235 | NaN | NaN | NaN | 300 | 840 | 1279 |
| 251 | NaN | NaN | NaN | 163 | 818 | 1259 |
| 267 | NaN | NaN | NaN | NaN | 797 | 1243 |
| 283 | NaN | NaN | NaN | NaN | 770 | 1225 |
| 299 | NaN | NaN | NaN | NaN | 743 | 1208 |

Example Seven

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [780, 656, 552, 464, 390, 328, 276, 232, 195, 164]$, and n = 10; N is a positive integer power of 2, including, but not limited to, one of: 32, 64, 128, 256, 512, or 1024; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 8 provides a specific example of the reliability threshold table. In another example, the reliability threshold table includes at least one row or at least one column in Table 8.

Table 8 Reliability threshold table when $\beta = [780, 656, 552, 464, 390, 328, 276, 232, 195, 164]$

| K N | 32 | 64 | 128 | 256 | 512 | 1024 |
|---|---|---|---|---|---|---|
| 25 | 396 | 898 | 1390 | 1966 | 2622 | 3402 |
| 35 | NaN | 755 | 1294 | 1861 | 2533 | 3313 |
| 43 | NaN | 635 | 1213 | 1802 | 2465 | 3251 |
| 51 | NaN | 508 | 1145 | 1740 | 2406 | 3201 |
| 59 | NaN | 328 | 1068 | 1688 | 2366 | 3149 |
| 67 | NaN | NaN | 1000 | 1629 | 2315 | 3102 |
| 75 | NaN | NaN | 935 | 1583 | 2273 | 3062 |
| 83 | NaN | NaN | 861 | 1541 | 2234 | 3025 |
| 91 | NaN | NaN | 792 | 1495 | 2202 | 2993 |
| 99 | NaN | NaN | 703 | 1450 | 2164 | 2969 |
| 107 | NaN | NaN | 622 | 1413 | 2127 | 2931 |

(continued)

| K<br>N | 32 | 64 | 128 | 256 | 512 | 1024 |
|---|---|---|---|---|---|---|
| 115 | NaN | NaN | 492 | 1375 | 2099 | 2900 |
| 123 | NaN | NaN | 328 | 1331 | 2069 | 2873 |
| 131 | NaN | NaN | NaN | 1292 | 2039 | 2850 |
| 139 | NaN | NaN | NaN | 1248 | 2009 | 2824 |
| 147 | NaN | NaN | NaN | 1211 | 1979 | 2798 |
| 155 | NaN | NaN | NaN | 1167 | 1950 | 2780 |
| 163 | NaN | NaN | NaN | 1130 | 1919 | 2753 |
| 171 | NaN | NaN | NaN | 1075 | 1895 | 2730 |
| 179 | NaN | NaN | NaN | 1025 | 1874 | 2705 |
| 187 | NaN | NaN | NaN | 987 | 1845 | 2685 |
| 195 | NaN | NaN | NaN | 942 | 1817 | 2663 |
| 203 | NaN | NaN | NaN | 882 | 1799 | 2647 |
| 219 | NaN | NaN | NaN | 755 | 1741 | 2603 |
| 235 | NaN | NaN | NaN | 604 | 1690 | 2570 |
| 251 | NaN | NaN | NaN | 328 | 1645 | 2529 |
| 267 | NaN | NaN | NaN | NaN | 1601 | 2496 |
| 283 | NaN | NaN | NaN | NaN | 1547 | 2460 |
| 299 | NaN | NaN | NaN | NaN | 1495 | 2427 |

Example Eight

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [51, 43, 36, 30, 25, 21, 18, 15, 13]$, and n = 9; N is a positive integer power of 2, including, but not limited to, one of: 32, 64, 128, 256, or 512; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 9 provides a specific example of the reliability threshold table. In another example, the reliability threshold table includes at least one row or at least one column in Table 9.

Table 9 Reliability threshold table when $\beta = [51, 43, 36, 30, 25, 21, 18, 15, 13]$

| K<br>N | 32 | 64 | 128 | 256 | 512 |
|---|---|---|---|---|---|
| 25 | 31 | 69 | 107 | 152 | 203 |
| 35 | NaN | 58 | 100 | 144 | 196 |
| 43 | NaN | 49 | 94 | 140 | 191 |
| 51 | NaN | 39 | 88 | 134 | 186 |
| 59 | NaN | 25 | 82 | 130 | 183 |
| 67 | NaN | NaN | 77 | 126 | 179 |
| 75 | NaN | NaN | 72 | 122 | 176 |
| 83 | NaN | NaN | 67 | 119 | 173 |

(continued)

| K / N | 32 | 64 | 128 | 256 | 512 |
|---|---|---|---|---|---|
| 91 | NaN | NaN | 61 | 115 | 170 |
| 99 | NaN | NaN | 54 | 112 | 168 |
| 107 | NaN | NaN | 48 | 109 | 165 |
| 115 | NaN | NaN | 38 | 106 | 163 |
| 123 | NaN | NaN | 25 | 103 | 160 |
| 131 | NaN | NaN | NaN | 100 | 158 |
| 139 | NaN | NaN | NaN | 97 | 155 |
| 147 | NaN | NaN | NaN | 94 | 153 |
| 155 | NaN | NaN | NaN | 90 | 151 |
| 163 | NaN | NaN | NaN | 87 | 148 |
| 171 | NaN | NaN | NaN | 83 | 147 |
| 179 | NaN | NaN | NaN | 79 | 145 |
| 187 | NaN | NaN | NaN | 76 | 143 |
| 195 | NaN | NaN | NaN | 73 | 140 |
| 203 | NaN | NaN | NaN | 68 | 139 |
| 219 | NaN | NaN | NaN | 58 | 135 |
| 235 | NaN | NaN | NaN | 46 | 131 |
| 251 | NaN | NaN | NaN | 25 | 127 |
| 267 | NaN | NaN | NaN | NaN | 124 |
| 283 | NaN | NaN | NaN | NaN | 120 |
| 299 | NaN | NaN | NaN | NaN | 115 |

Example Nine

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [101, 85, 71, 60, 50, 42, 35, 30, 25]$, and n = 9; N is a positive integer power of 2, including, but not limited to, one of: 32, 64, 128, 256, or 512; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 10 provides a specific example of the reliability threshold table. In another example, the reliability threshold table includes at least one row or at least one column in Table 10.

Table 10 Reliability threshold table when $\beta = [101, 85, 71, 60, 50, 42, 35, 30, 25]$

| K / N | 32 | 64 | 128 | 256 | 512 |
|---|---|---|---|---|---|
| 25 | 60 | 137 | 212 | 301 | 402 |
| 35 | NaN | 115 | 198 | 285 | 389 |
| 43 | NaN | 97 | 186 | 276 | 378 |
| 51 | NaN | 77 | 175 | 266 | 368 |
| 59 | NaN | 50 | 163 | 258 | 363 |

(continued)

| K / N | 32 | 64 | 128 | 256 | 512 |
|---|---|---|---|---|---|
| 67 | NaN | NaN | 152 | 250 | 354 |
| 75 | NaN | NaN | 143 | 242 | 348 |
| 83 | NaN | NaN | 132 | 236 | 343 |
| 91 | NaN | NaN | 121 | 228 | 338 |
| 99 | NaN | NaN | 107 | 222 | 332 |
| 107 | NaN | NaN | 95 | 216 | 326 |
| 115 | NaN | NaN | 75 | 211 | 322 |
| 123 | NaN | NaN | 50 | 203 | 317 |
| 131 | NaN | NaN | NaN | 198 | 313 |
| 139 | NaN | NaN | NaN | 191 | 308 |
| 147 | NaN | NaN | NaN | 186 | 303 |
| 155 | NaN | NaN | NaN | 178 | 299 |
| 163 | NaN | NaN | NaN | 173 | 294 |
| 171 | NaN | NaN | NaN | 165 | 291 |
| 179 | NaN | NaN | NaN | 157 | 287 |
| 187 | NaN | NaN | NaN | 151 | 283 |
| 195 | NaN | NaN | NaN | 145 | 278 |
| 203 | NaN | NaN | NaN | 135 | 276 |
| 219 | NaN | NaN | NaN | 115 | 267 |
| 235 | NaN | NaN | NaN | 92 | 258 |
| 251 | NaN | NaN | NaN | 50 | 252 |
| 267 | NaN | NaN | NaN | NaN | 246 |
| 283 | NaN | NaN | NaN | NaN | 237 |
| 299 | NaN | NaN | NaN | NaN | 228 |

Example Ten

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [206, 173, 145, 122, 102, 86, 73, 61, 51]$, and n = 9; N is a positive integer power of 2, including, but not limited to, one of: 32, 64, 128, 256, or 512; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 11 provides a specific example of the reliability threshold table. In another example, the reliability threshold table includes at least one row or at least one column in Table 11.

Table 11 Reliability threshold table when $\beta = [206, 173, 145, 122, 102, 86, 73, 61, 51]$

| K / N | 32 | 64 | 128 | 256 | 512 |
|---|---|---|---|---|---|
| 25 | 124 | 281 | 434 | 615 | 821 |

(continued)

| K / N | 32 | 64 | 128 | 256 | 512 |
|---|---|---|---|---|---|
| 35 | NaN | 236 | 404 | 582 | 793 |
| 43 | NaN | 198 | 379 | 564 | 772 |
| 51 | NaN | 159 | 358 | 544 | 752 |
| 59 | NaN | 102 | 333 | 528 | 740 |
| 67 | NaN | NaN | 312 | 509 | 724 |
| 75 | NaN | NaN | 292 | 495 | 711 |
| 83 | NaN | NaN | 269 | 481 | 699 |
| 91 | NaN | NaN | 247 | 467 | 689 |
| 99 | NaN | NaN | 220 | 454 | 677 |
| 107 | NaN | NaN | 195 | 442 | 666 |
| 115 | NaN | NaN | 153 | 430 | 658 |
| 123 | NaN | NaN | 102 | 416 | 648 |
| 131 | NaN | NaN | NaN | 404 | 638 |
| 139 | NaN | NaN | NaN | 391 | 628 |
| 147 | NaN | NaN | NaN | 379 | 618 |
| 155 | NaN | NaN | NaN | 365 | 610 |
| 163 | NaN | NaN | NaN | 353 | 600 |
| 171 | NaN | NaN | NaN | 336 | 593 |
| 179 | NaN | NaN | NaN | 320 | 587 |
| 187 | NaN | NaN | NaN | 308 | 577 |
| 195 | NaN | NaN | NaN | 295 | 567 |
| 203 | NaN | NaN | NaN | 275 | 564 |
| 219 | NaN | NaN | NaN | 236 | 544 |
| 235 | NaN | NaN | NaN | 188 | 528 |
| 251 | NaN | NaN | NaN | 102 | 515 |
| 267 | NaN | NaN | NaN | NaN | 501 |
| 283 | NaN | NaN | NaN | NaN | 485 |
| 299 | NaN | NaN | NaN | NaN | 467 |

Example Eleven

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [480, 404, 340, 286, 240, 202, 170, 143, 120]$, and $n = 9$; N is a positive integer power of 2, including, but not limited to, one of: 32, 64, 128, 256, or 512; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 12 provides a specific example of the reliability threshold table. In another example, the reliability threshold table includes at least one row or at least one column in Table 12.

Table 12 Reliability threshold table when β = [480, 404, 340, 286, 240, 202, 170, 143, 120]

| K N | 32 | 64 | 128 | 256 | 512 |
|---|---|---|---|---|---|
| 25 | 290 | 658 | 1018 | 1440 | 1920 |
| 35 | NaN | 553 | 948 | 1363 | 1855 |
| 43 | NaN | 465 | 889 | 1320 | 1805 |
| 51 | NaN | 372 | 839 | 1274 | 1762 |
| 59 | NaN | 240 | 782 | 1236 | 1732 |
| 67 | NaN | NaN | 732 | 1193 | 1695 |
| 75 | NaN | NaN | 685 | 1159 | 1665 |
| 83 | NaN | NaN | 631 | 1129 | 1636 |
| 91 | NaN | NaN | 580 | 1095 | 1612 |
| 99 | NaN | NaN | 515 | 1062 | 1584 |
| 107 | NaN | NaN | 456 | 1035 | 1557 |
| 115 | NaN | NaN | 360 | 1007 | 1537 |
| 123 | NaN | NaN | 240 | 975 | 1515 |
| 131 | NaN | NaN | NaN | 946 | 1493 |
| 139 | NaN | NaN | NaN | 914 | 1471 |
| 147 | NaN | NaN | NaN | 887 | 1449 |
| 155 | NaN | NaN | NaN | 855 | 1428 |
| 163 | NaN | NaN | NaN | 828 | 1405 |
| 171 | NaN | NaN | NaN | 787 | 1387 |
| 179 | NaN | NaN | NaN | 751 | 1372 |
| 187 | NaN | NaN | NaN | 723 | 1351 |
| 195 | NaN | NaN | NaN | 690 | 1331 |
| 203 | NaN | NaN | NaN | 646 | 1317 |
| 219 | NaN | NaN | NaN | 553 | 1275 |
| 235 | NaN | NaN | NaN | 442 | 1238 |
| 251 | NaN | NaN | NaN | 240 | 1205 |
| 267 | NaN | NaN | NaN | NaN | 1173 |
| 283 | NaN | NaN | NaN | NaN | 1133 |
| 299 | NaN | NaN | NaN | NaN | 1095 |

Example Twelve

A reliability threshold is obtained from a preset mapping relationship according to an index value. In this example, the index value is determined according to a value of a number K of information bits and a value of a code rate R, and a mapping relationship between the number K of information bits, the code rate R, and the reliability threshold is recorded through a reliability threshold table, and elements in the reliability threshold table are determined based on the quantization weight value sequence β.

For example, the quantization weight value sequence is β = [$\beta_{n-1}$, $\beta_{n-2}$, ..., $\beta_0$] = [97, 165, 139, 116, 98, 82, 68, 58, 49, 41], and n = 10; R is a real number greater than 0 and less than 1, including, but not limited to, one of: 25/32, 25/64, 25/128, 25/256, 25/512, 25/1024, 35/64, 35/128, 35/256, 35/512, 35/1024, 43/64, 43/128, 43/256, 43/512, 43/1024, 51/64, 51/128, 51/256, 51/512, 51/1024, 59/64, 59/128, 59/256, 59/512, or 59/1024; and K is a positive integer, including, but not limited to, one of: 25, 35, 43, 51, or 59. Table 13 provides a specific example of the reliability threshold table. In another example, the reliability threshold table includes at least one row or at least one column in Table 13.

Table 13 Reliability threshold table indexed by K and R when β = [197, 165, 139, 116, 98, 82, 68, 58, 49, 41]

| K=25 | R | 25/32 | 25/64 | 25/128 | 25/256 | 25/512 | 25/1024 |
|---|---|---|---|---|---|---|---|
| | $w_{K,R}$ | 99 | 224 | 347 | 493 | 658 | 855 |
| K=35 | R | 35/32 | 35/64 | 35/128 | 35/256 | 35/512 | 35/1024 |
| | $w_{K,R}$ | NaN | 189 | 323 | 467 | 635 | 832 |
| K=43 | R | 43/32 | 43/64 | 43/128 | 43/256 | 43/512 | 43/1024 |
| | $w_{K,R}$ | NaN | 158 | 304 | 452 | 618 | 816 |
| K=51 | R | 51/32 | 51/64 | 51/128 | 51/256 | 51/512 | 51/1024 |
| | $w_{K,R}$ | NaN | 126 | 287 | 436 | 602 | 805 |
| K=59 | R | 59/32 | 59/64 | 59/128 | 59/256 | 59/512 | 59/1024 |
| | 59 | NaN | 82 | 266 | 422 | 593 | 790 |

Example Thirteen

A reliability threshold is obtained from a preset mapping relationship according to an index value. In this example, the index value is determined according to a value of a number K of information bits and a value of a code rate R, and a mapping relationship between the number K of information bits, the code rate R, and the reliability threshold is recorded through a reliability threshold table, and elements in the reliability threshold table are determined based on the quantization weight value sequence β.

For example, the quantization weight value sequence is β = [β_{n-1}, β_{n-2}, ..., β_0] = [480, 404, 340, 286, 240, 202, 170, 143, 120], and n = 9; R is a real number greater than 0 and less than 1, including, but not limited to, one of: 25/32, 25/64, 25/128, 25/256, 25/512, 35/64, 35/128, 35/256, 35/512, 43/64, 43/128, 43/256, 43/512, 51/64, 51/128, 51/256, 51/512, 59/64, 59/128, 59/256, or 59/512; and K is a positive integer, including, but not limited to, one of: 25, 35, 43, 51, or 59. Table 14 provides a specific example of the reliability threshold table. In another example, the reliability threshold table includes at least one row or at least one column in Table 14.

Table 14 Reliability threshold table indexed by K and R when β = [480, 404, 340, 286, 240, 202, 170, 143, 120]

| K=25 | R | 25/32 | 25/64 | 25/128 | 25/256 | 25/512 |
|---|---|---|---|---|---|---|
| | $w_{K,R}$ | 290 | 658 | 1018 | 1440 | 1920 |
| K=35 | R | 35/32 | 35/64 | 35/128 | 35/256 | 35/512 |
| | $w_{K,R}$ | NaN | 553 | 948 | 1363 | 1855 |
| K=43 | R | 43/32 | 43/64 | 43/128 | 43/256 | 43/512 |
| | $w_{K,R}$ | NaN | 465 | 889 | 1320 | 1805 |
| K=51 | R | 51/32 | 51/64 | 51/128 | 51/256 | 51/512 |
| | $w_{K,R}$ | NaN | 372 | 839 | 1274 | 1762 |
| K=59 | R | 59/32 | 59/64 | 59/128 | 59/256 | 59/512 |
| | 59 | NaN | 240 | 782 | 1236 | 1732 |

Example Fourteen

A subchannel reliability value is calculated based on Gray mapping and a quantization weight value sequence. When a natural order subchannel index number takes values in ascending order as 0, 1, 2, ..., N-1, a natural order subchannel index number i-1 is converted to a subchannel index number $g_{i-1}$ by Gray mapping, and a reliability value $w'_{g_i}$ of a $g_i$th subchannel is calculated according to a reliability value $w'_{g_{i-1}}$ of a $g_{i-1}$th subchannel. In other words, when the reliability value $w'_{g_{i-1}}$ of the $g_{i-1}$th subchannel is known, the reliability value $w'_{g_i}$ of the $g_i$th subchannel is calculated according to $w'_{g_i}$ , and similarly, a reliability value $w'_{g_{i+1}}$ of a $g_{i+1}{}^{th}$ subchannel can be calculated according to $w'_{g_i}$ , as shown by the following formula.

$$w'_{g_i} = w'_{g_{i-1}} + \left(1 - 2 \cdot B_{e+1}\right) \cdot \beta_e$$

where i is expressed in binary form as i = $B_{n-1}B_{n-2}...B_2B_1B_0$; $B_j$ represents a $j^{th}$ bit corresponding to the integer i in the binary form and has a value of bit 0 or bit 1, where j = 0, 1, 2, ..., n-2, n-1; e is a position where 1 first appears starting from a $0^{th}$ bit $B_0$ of $B_{n-1}B_{n-2}...B_2B_1B_0$ (i.e., $B_e = 1$ and $B_{e-1} = B_{e-2} = ..., = B_0 = 0$), $B_e$ is a bit value of this position, and $B_{e+1}$ is a bit value of an $(e+1)^{th}$ bit; and $\beta_e$ is an $e^{th}$ element in the quantization weight value sequence β.

A subchannel reliability value is calculated based on Gray mapping and a quantization weight value sequence. When a natural order subchannel index number takes values in descending order as N-1, N-2, N-3, ..., 0, a natural order subchannel index number i+1 is converted to a subchannel index number $g_{i+1}$ by Gray mapping, and a reliability value $w'_{g_i}$ of a $g_i{}^{th}$ subchannel is calculated according to a reliability value $w'_{g_{i+1}}$ of a $g_{i+1}{}^{th}$ subchannel. Similarly, a reliability value $w'_{g_{i-1}}$ of a $g_{i-1}{}^{th}$ subchannel can be calculated according to $w'_{g_i}$ . $w'_{g_i}$ is calculated based on the following formula.

$$w'_{g_i} = w'_{g_{i+1}} - \left(1 - 2 \cdot B_{e+1}\right) \cdot \beta_e$$

where i+1 is expressed in binary form as i+1 = $B_{n-1}B_{n-2}...B_2B_1B_0$; $B_j$ represents a $j^{th}$ bit corresponding to the integer i+1 in the binary form and has a value of bit 0 or bit 1; j $\in$ {0, 1, ..., n-1}; e is a position where a bit of 1 first appears starting from a $0^{th}$ bit $B_0$ of $B_{n-1}B_{n-2}...B_2B_1B_0$ (i.e., $B_e = 1$ and $B_{e-1} = B_{e-2} = ..., = B_0 = 0$); $B_e$ is a bit value of this position; $B_{e+1}$ is a bit value of an $(e+1)^{th}$ bit; $\beta_e$ is an $e^{th}$ element in the quantization weight value sequence β; and e $\in$ {0, 1, ..., n-1}.

Compared with calculating the reliability value of the $g_i{}^{th}$ subchannel according to the following formula, by the above implementation, the reliability value of the current subchannel can be quickly obtained according to the reliability value of the previous subchannel, thereby reducing multiplication operations and reducing the amount of calculation.

$$w'_{g_i} = \sum_{j=0}^{n-1} b_j \cdot \beta_j$$

where n = $\log_2(N)$ represents a number of bits required to express the integer N; i is an integer greater than or equal to 0 and less than N, $g_i$ is a Gray code decimal number corresponding to i, and $g_i$ is expressed in binary form as $g_i = b_{n-1}b_{n-2}...b_2b_1b_0$; $b_j$ represents a $j^{th}$ bit corresponding to the integer $g_i$ in the binary form and has a value of bit 0 or bit 1, where j = 0, 1, 2, ..., n-2, n-1; and $\beta_j$ is an element in the quantization weight value sequence β, and has a value which is an integer greater than 0.

It can be understood that the quantization weight value sequence β includes one of: β = [$\beta_{n-1}$, $\beta_{n-2}$, ..., $\beta_0$] is a sequence of positive integers in descending order; or β = [$\beta_0$, $\beta_1$, ..., $\beta_{n-1}$] is a sequence of positive integers in ascending order.

It can be understood that a feature of the quantization weight value sequence β includes one of: the quantization weight value sequence β includes n quantization weight values, and $\beta_j$ is a quantization weight value corresponding to $B_j$. n = $\log_2 N$, N is the number of polarized subchannels, j $\in$ {0, 1, 2, ..., n-2, n-1}, $B_j$ represents a $j^{th}$ bit in the integer i in binary form, i = $B_{n-1}B_{n-2}...B_2B_1B_0$, a $0^{th}$ bit $B_0$ is the lowest bit, and an $(n-1)^{th}$ bit $B_{n-1}$ is the highest bit.

It can be understood that the quantization weight value sequence β = [$\beta_{n-1}$, $\beta_{n-2}$, ..., $\beta_0$] satisfies $\beta_{n-1}+\beta_{n-02}+...+\beta_0$ < M, where M is a positive integer power of 2. Specifically, A value of M includes at least one of: 256, 512, 1024, 2048, or 4096.

It can be understood that the quantization weight value sequence β = [$\beta_{n-1}$, $\beta_{n-2}$, ..., $\beta_0$] is determined in at least one of the following manners: the quantization weight value sequence is preset, the quantization weight value sequence is determined according to a sum of elements $\beta_{n-1}+\beta_{n-2}+...+\beta_0$ < M, or the quantization weight value sequence is determined according to a constraint condition that a number of differences between a quantized PW sequence obtained by the quantization weight value sequence and a PW sequence is not greater than a second value D. M is a positive integer power of 2, and a value of M includes, but not limited to, one of: 256, 512, 1024, 2048, or 4096. $\beta_j$ is a positive integer, j $\in$ {0, 1, 2, ..., n-2, n-1}, and n = $\log_2 N$. D is an integer greater than or equal to 0 and less than N.

It can be understood that when the value of D is small, the obtained number of differences between the quantized PW sequence and the PW sequence is small, but a larger M is required to satisfy the storage of the quantized PW sequence, i.e., more storage space is required to store the reliability threshold; and when the value of D is large, the obtained number of differences between the quantized PW sequence and the PW sequence is large, and the storage of the quantized PW sequence does not require a large M, i.e., only a small storage space is required to store the reliability threshold. Different application scenarios can be met by adjusting the value of D.

In an example, M = 256, N = 512, n = 9, D = 254, and the quantization weight value sequence is $\beta = [\beta_{n-1}, \beta_{n-2}, ..., \beta_0] = [51, 43, 36, 30, 25, 21, 18, 15, 13]$, where the quantization weight value sequence $\beta$ satisfies: the sum of elements in the sequence is $\beta_{n-1}+\beta_{n-2}+...+\beta_0 = 252 < M$. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 254 and is not greater than D, i.e., there are 254 positions at which $PW_{qun}(i) \neq PW(i)$, i = 0, 1, ..., N-1.

In another example, M = 512, N = 512, n = 9, D = 76, and the quantization weight value sequence is $\beta = [\beta_{n-1}, \beta_{n-2}, ..., \beta_0] = [101, 85, 71, 60, 50, 42, 35, 30, 25]$, where the quantization weight value sequence $\beta$ satisfies the following feature: the sum of elements in the sequence is $\beta_{n-1}+\beta_{n-2}+...+\beta_0 = 499 < M$. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 76 and is not greater than D, i.e., there are 76 positions at which $PW_{quan}(i) \neq PW(i)$, i = 0, 1, ..., N-1.

In still another example, M = 1024, N = 512, n = 9, D = 6, and the quantization weight value sequence is $\beta = [\beta_{n-1}, \beta_{n-2}, ..., \beta_0] = [206, 173, 145, 122, 102, 86, 73, 61, 51]$, where the quantization weight value sequence $\beta$ satisfies the following feature: the sum of elements in the sequence is $\beta_{n-1}+\beta_{n-2}+...+\beta_0 = 1019 < M$. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 6 and is not greater than D, i.e., there are 6 positions at which $PW_{quan}(i) \neq PW(i)$, i = 0, 1, ..., N-1.

In yet another example, M = 4096, N = 512, n = 9, D = 0, and the quantization weight value sequence is $\beta = [\beta_{n-1}, \beta_{n-2}, ..., \beta_0] = [480, 404, 340, 286, 240, 202, 170, 143, 120]$, where the quantization weight value sequence $\beta$ satisfies the following feature: the sum of elements in the sequence is $\beta_{n-1}+\beta_{n-2}+...+\beta_0 = 2385 < M$. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 0 and is not greater than D, i.e., there are 0 positions at which $PW_{quan}(i) \neq PW(i)$, i = 0, 1, ..., N-1.

In yet another example, M = 512, N = 1024, n = 10, D = 466, and the quantization weight value sequence is $\beta = [\beta_{n-1}, \beta_{n-2}, ..., \beta_0] = [96, 81, 68, 57, 48, 40, 34, 28, 24, 20]$, where the quantization weight value sequence $\beta$ satisfies the following feature: the sum of elements in the sequence is $\beta_{n-1}+\beta_{n-2}+...+\beta_0 = 496 < M$. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 466 and is not greater than D, i.e., there are 466 positions at which $PW_{quan}(i) \neq PW(i)$, i = 0, 1, ..., N-1.

In yet another example, M = 1024, N = 1024, n = 10, D = 70, and the quantization weight value sequence is $\beta = [\beta_{n-1}, \beta_{n-2}, ..., \beta_0] = [197, 165, 139, 116, 98, 82, 68, 58, 49, 41]$, where the quantization weight value sequence $\beta$ satisfies the following feature: the sum of elements in the sequence is $\beta_{n-1}+\beta_{n-2}+...+\beta_0 = 1013 < M$. An $i^{th}$ subchannel reliability value $w'_i$

is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 70 and is not greater than D, i.e., there are 70 positions at which $PW_{quan}(i) \neq PW(i)$, i = 0, 1, ..., N-1.

In yet another example, M = 2048, N = 1024, n = 10, D = 24, and the quantization weight value sequence is $\beta$ = $[\beta_{n-1}, \beta_{n-2}, ..., \beta_0]$ = [389, 327, 275, 231, 194, 163, 137, 115, 97, 82], where the quantization weight value sequence $\beta$ satisfies the following feature: the sum of elements in the sequence is $\beta_{n-1}+\beta_{n-2}+...+ \beta_0$ = 2010 < M. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 24 and is not greater than D, i.e., there are 24 positions at which $PW_{quan}(i) \neq PW(i)$, i = 0, 1, ..., N-1.

In yet another example, M = 4096, N = 1024, n = 10, D = 0, and the quantization weight value sequence is $\beta$ = $[\beta_{n-1}, \beta_{n-2}, ..., \beta_0]$ = [780, 656, 552, 464, 390, 328, 276, 232, 195, 164], where the quantization weight value sequence $\beta$ satisfies the following feature: the sum of elements in the sequence is $\beta_{n-1}+\beta_{n-2}+...+\beta_0$ = 4037 < M. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 0 and is not greater than D, i.e., there are 0 positions at which $PW_{quan}(i) \neq PW(i)$, i = 0, 1, ..., N-1.

Example Fifteen

An information and frozen bit indication corresponding to each of the polarized subchannels is determined according to the subchannel reliability values corresponding to the polarized subchannels and a reliability threshold. A specific implementation process may be as follows: when the subchannel reliability value corresponding to the polarized subchannel is greater than or equal to the reliability threshold, the information and frozen bit indication corresponding to the polarized subchannel is a first indication value, and the first indication value indicates that the polarized subchannel carries an information bit; and when the subchannel reliability value corresponding to the polarized subchannel is less than the reliability threshold, the information and frozen bit indication corresponding to the polarized subchannel is a second indication value, and the second indication value indicates that the polarized subchannel carries a frozen bit.

For example, an information and frozen bit indication corresponding to the $g_i^{th}$ subchannel is represented by a flag bit F, and if $w'_{g_i} \geq \mathbf{w_{th_i}}$, F = $b_1$, indicating that the $g_i^{th}$ subchannel carries information bits; otherwise, F = $b_0$, indicating that the $g_i^{th}$ subchannel carries frozen bits. $b_0$ and $b_1$ are two binary bit values which are not equal. In a specific example, if $w'_{g_i} \geq \mathbf{w_{th_i}}$, F = 1, indicating that the $g_i^{th}$ subchannel carries information bits; otherwise, F = 0, indicating that the $g_i^{th}$ subchannel carries frozen bits.

Example Sixteen

It can be understood that the finally obtained information and frozen bit sequence and the information bit sequence satisfy the following mapping relationship $u_{f1(j)} = a_{f2(j)}$, where f1 is a function of j, and is determined according to, for example, but not limited to, f2(j), a Gray map, an information and frozen bit indication, and an information index number, and f1(j) $\in$ {0, 1, ..., N-1}; f2 is a function of j, including, but not limited to, f(j)=j and f(j)=K-j; f2(j) $\in$ {0, 1, ..., K-1}; and j = 0, 1, ..., K-1.

In an example, the initial information and frozen bit sequence u satisfies $[u_{gr}, u_{gr+1}, u_{gr+2}, ..., u_{gr+K-1}]$ = $[a_0, a_1, ..., a_{k-1}]$, and when r = 0, it indicates that a $j^{th}$ information bit $a_j$ in the information bit sequence is set at a $g_j^{th}$ position in the initial information and frozen bit sequence, where j is any integer from 0 to K-1, and $g_j$ is a Gray code decimal number corresponding to j. Then, based on the information and frozen bit indication corresponding to the subchannel, the information and frozen bit sequence u is updated again. For details, reference may be made to a logic code shown in FIG. 9, including:

(1) setting an initial value of the information index number to k = K-1, and a Gray code decimal number $g_k$ corresponding to the initial value of k points to the last information bit $a_{K-1}$ in u;
(2) setting the initial value of the subchannel index number to $g_i$, where i = N-1;
(3) cyclically performing the following process N times: if k ≥ 0 and F = 1, then $u_{g_i} = u_{g_k}$, where k = k - 1, and i = i - 1; otherwise, $u_{g_i} = 0$, and i = i - 1; and
(4) when i = 0, the update of the information and frozen bit sequence is completed, and a final information and frozen bit sequence is obtained.

N is the number of polarized subchannels and has a value which is a positive integer power of 2. K is the number of information bits and has a value which is a positive integer, and K < N. F = 1 indicates that the $i^{th}$ subchannel carries information bits. F = 0 indicates that the $i^{th}$ subchannel carries frozen bits.

Example Seventeen

The initial information and frozen bit sequence u satisfies $[u_{g_r}, u_{g_{r+1}}, u_{g_{r+2}}, ..., u_{g_{r+K-1}}] = [a_0, a_1, ..., a_{K-1}]$, and when r = N-K, it indicates that a $j^{th}$ information bit $a_j$ in the information bit sequence is set at a $g_{N-K+j}^{th}$ position in the initial information and frozen bit sequence, where j is any integer from 0 to K-1, and $g_{N-K+j}$ represents a Gray code decimal number corresponding to (N-K+j). Then, based on the information and frozen bit indication corresponding to the subchannel, the information and frozen bit sequence u is updated again. For details, reference may be made to a logic code shown in FIG. 10, including:

(1) setting an initial value of the information index number to k = N-K, and a Gray code decimal number $g_k$ corresponding to the initial value of k points to the first information bit $a_0$ in u;
(2) setting the initial value of the subchannel index number to $g_i$, where i = 0;
(3) cyclically performing the following process N times: if k ≥ 0 and F = 1, then $u_{g_i} = u_{g_k}$, where k = k + 1, and i = i + 1; otherwise, $u_{g_i} = 0$, and i = i + 1; and
(4) when i = N-1, the update of the information and frozen bit sequence is completed, and a final information and frozen bit sequence is obtained.

N is the number of polarized subchannels and has a value which is a positive integer power of 2. K is the number of information bits and has a value which is a positive integer, and K < N. F = 1 indicates that the $i^{th}$ subchannel carries information bits. F = 0 indicates that the $i^{th}$ subchannel carries frozen bits.

Example Eighteen

The initial information and frozen bit sequence u satisfies $[u_{g_r}, u_{g_{r+1}}, u_{g_{r+2}}, ..., u_{g_{r+K-1}}] = [a_{K-1}, a_{K-2}, a_{K-3}, ..., a_0]$, and when r = 0, it indicates that a $(K-1-j)^{th}$ information bit $a_{K-1-j}$ in the information bit sequence is set at a $g_j^{th}$ position in the initial information and frozen bit sequence, where j is any integer from 0 to K-1, and $g_j$ is a Gray code decimal number corresponding to j. Then, based on the information and frozen bit indication corresponding to the subchannel, the information and frozen bit sequence u is updated again. For details, reference may be made to a logic code shown in FIG. 11, including:

(1) setting an initial value of the information index number to k = K-1, and a Gray code decimal number $g_k$ corresponding to the initial value of k points to the first information bit $a_0$ in u;
(2) setting the initial value of the subchannel index number to $g_i$, where i = N-1;
(3) cyclically performing the following process N times: if k ≥ 0 and F = 1, then $u_{g_i} = u_{g_k}$, where k = k - 1, and i = i - 1; otherwise, $u_{g_i} = 0$, and i = i - 1; and
(4) when i = 0, the update of the information and frozen bit sequence is completed, and a final information and frozen bit sequence is obtained.

N is the number of polarized subchannels and has a value which is a positive integer power of 2. K is the number of information bits and has a value which is a positive integer, and K < N. F = 1 indicates that the $i^{th}$ subchannel carries information bits. F = 0 indicates that the $i^{th}$ subchannel carries frozen bits.

Example Nineteen

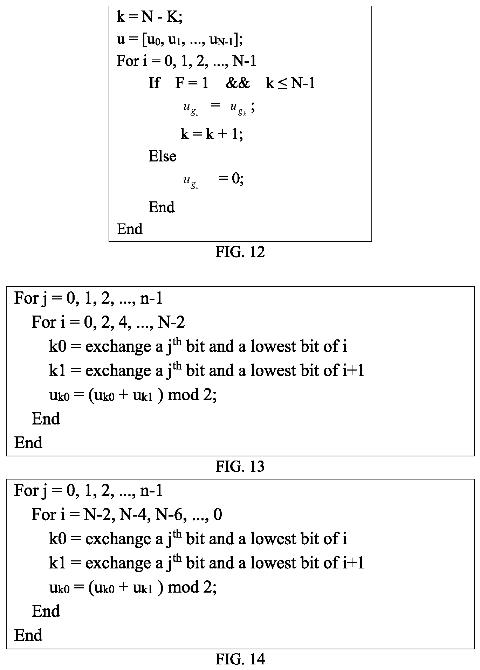

The initial information and frozen bit sequence u satisfies $[u_{g_r}, u_{g_{r+1}}, u_{g_{r+2}}, ..., u_{g_{r+K-1}}] = [a_{K-1}, a_{K-2}, a_{K-3}, ..., a_0]$, and when r = N-K, it indicates that a $(K-1-j)^{th}$ information bit $a_{K-1-j}$ in the information bit sequence is set at a $g_{N-K+j}^{th}$ position in the initial information and frozen bit sequence, where j is any integer from 0 to K-1, and $g_{N-K+j}$ represents a Gray code decimal number corresponding to (N-K+j). Then, based on the information and frozen bit indication corresponding to the subchannel, the information and frozen bit sequence u is updated again. For details, reference may be made to a logic code shown in FIG. 12, including:

(1) setting an initial value of the information index number to k = N-K, and a Gray code decimal number $g_k$ corresponding to the initial value of k points to the last information bit $a_{k-1}$ in u;
(2) setting the initial value of the subchannel index number to $g_i$, where i = 0;
(3) cyclically performing the following process N times: if k ≥ 0 and F = 1, then $u_{g_i} = u_{g_k}$, where k = k + 1, and i = i + 1; otherwise, $u_{g_i} = 0$, and i = i + 1; and
(4) when i = N-1, the update of the information and frozen bit sequence is completed, and a final information and frozen bit sequence is obtained.

N is the number of polarized subchannels and has a value which is a positive integer power of 2. K is the number of information bits and has a value which is a positive integer, and K < N. F = 1 indicates that the $i^{th}$ subchannel carries information bits. F = 0 indicates that the $i^{th}$ subchannel carries frozen bits.

Example Twenty

In the embodiments of the present disclosure, after an information and frozen bit sequence $u = [u_0, u_1, ..., u_{N-1}]$ is obtained, the information and frozen bit sequence $u = [u_0, u_1, ..., u_{N-1}]$ is serially encoded to obtain encoded data $d = [d_0, d_1, ..., d_{N-1}]$. Intermediate encoded bits of each stage are stored in storage space of the information and frozen bit sequence, bits are calculated in groups of two in each stage, and the encoding process is serially performed in an order of Stage 0, Stage 1, ..., and Stage n-1. As such, storing the intermediate encoded bits of each stage in the storage space of the information and frozen bit sequence can reduce the storage overhead.

For example, the information and frozen bit sequence is processed in ascending order of subchannel index numbers, and the specific processing process may include: processing the information and frozen bit sequence in ascending order of subchannel index numbers, calculating bits in groups of two in each stage, and storing intermediate encoded bits of each stage in the storage space of the information and frozen bit sequence, and serially performing the encoding process in the order of Stage 0, Stage 1, ..., and Stage n-1.

Example Twenty-one

Referring to FIG. 13, a process of encoding an information and frozen bit sequence $u = [u_0, u_1, ..., u_{N-1}]$ to obtain encoded data may include the following operations: processing the information and frozen bit sequence in ascending order of subchannel index numbers i = 0, 2, 4, ..., N-2; performing calculation by using two bits at positions k0 and k1 of the subchannel index number in each stage as a group; in each stage, storing an intermediate encoded bit $(u_{k0} + u_{k1})$ mod 2 using a $k0^{th}$ position of the information and frozen bit sequence u; and serially performing the encoding process in the order of Stage 0, Stage 1, ..., and Stage n-1 according to j = 0, 1, 2, ..., n-1, where j represents a stage index number of polar coding.

Here, $u = [u_0, u1, ..., u_{N-1}]$ is the information and frozen bit sequence outputted in S210; i represents the subchannel index number, i is expressed in binary form as $i = B_{n-1}B_{n-2}...B_{j+1}B_jB_{j-1}...B_2B_1B_0$, and B0 represents the lowest bit; and mod 2 means finding modulo to 2. k0 represents a decimal number obtained by exchanging a $j^{th}$ bit and the lowest bit of i, and k1 represents a decimal number obtained by exchanging a $j^{th}$ bit and the lowest bit of i+1. In an example, i is an even number, $B_0 = 0$, the $j^{th}$ bit $B_j$ and the lowest bit $B_0$ of $i = B_{n-1}B_{n-2}...B_{j+1}B_jB_{j-1}...B_2B_1B_0$ are exchanged to obtain $k_0 = B_{n-1}B_{n-2}...B_{j+1}B_0B_{j-1}...B_2B_1B_j$. In a specific example, i = 10d = 1010b, j = 3, the $j^{th}$ bit and the lowest bit of i are exchanged to obtain k0 = 0011b = 3d. In an example, i is an even number, the lowest bit $B_0$ in $i+1 = B_{n-1}B_{n-2}...B_{j+1}B_jB_{j-1}...B_2B_1B_0$ is equal to 1, the $j^{th}$ bit $B_j$ and the lowest bit $B_0$ of $i+1 = B_{n-1}B_{n-2}...B_{j+1}B_jB_{j-1}...B_2B_1B_0$ are exchanged to obtain $k1 = B_{n-1}B_{n-2}...B_{j+1}B_0B_{j-1}...B_2B_1B_j$. In a specific example, i+1 = 1011b = 11d, j = 3, the $j^{th}$ bit and the lowest bit of i+1 are exchanged to obtain k1 = 1011b = 11d.

Example Twenty-two

Referring to FIG. 14, a process of encoding an information and frozen bit sequence $u = [u_0, u_1, ..., u_{N-1}]$ to obtain encoded data may include the following operations: processing the information and frozen bit sequence in ascending order of subchannel index numbers i = N-2, N-4, N-6, ..., 0; performing calculation by using two bits at positions k0 and k1 of the subchannel index number in each stage as a group; in each stage, storing an intermediate encoded bit $(u_{k0} + u_{k1})$ mod 2 using a k0$^{th}$ position of the information and frozen bit sequence u; and serially performing the encoding process in the order of Stage 0, Stage 1, ..., and Stage n-1 according to j = 0, 1, 2, ..., n-1, where j represents a stage index number of polar coding.

Here, u = [$u_0$, u1, ..., $u_{N-1}$] is the information and frozen bit sequence outputted in S210; i represents the subchannel index number, i is expressed in binary form as i = $B_{n-1}B_{n-2}...B_{j+1}B_jB_{j-1}...B_2B_1B_0$, and B0 represents the lowest bit; and mod 2 means finding modulo to 2. k0 represents a decimal number obtained by exchanging a j$^{th}$ bit and the lowest bit of i, and k1 represents a decimal number obtained by exchanging a j$^{th}$ bit and the lowest bit of i+1.

In accordance with a second aspect of the present disclosure, an embodiment provides a data processing method, which can be applied to the second transmission node 120 shown in FIG. 2. The data processing method includes: receiving an encoded data sequence sent by a transmit end. The encoded data sequence includes N pieces of encoded data. The encoded data sequence is obtained by performing the following operations: mapping information bits in an information bit sequence to an information and frozen bit sequence according to a Gray mapping rule, and encoding the information and frozen bit sequence to obtain the encoded data sequence, where the information bit sequence includes K information bits, K is an integer greater than 0, the information and frozen bit sequence includes N bits, N represents a number of polarized subchannels, and N is an integer greater than K.

It can be understood that after the encoded data sequence sent by the transmit end is received, the encoded data sequence may be decoded according to the Gray mapping rule to obtain the original information bit sequence.

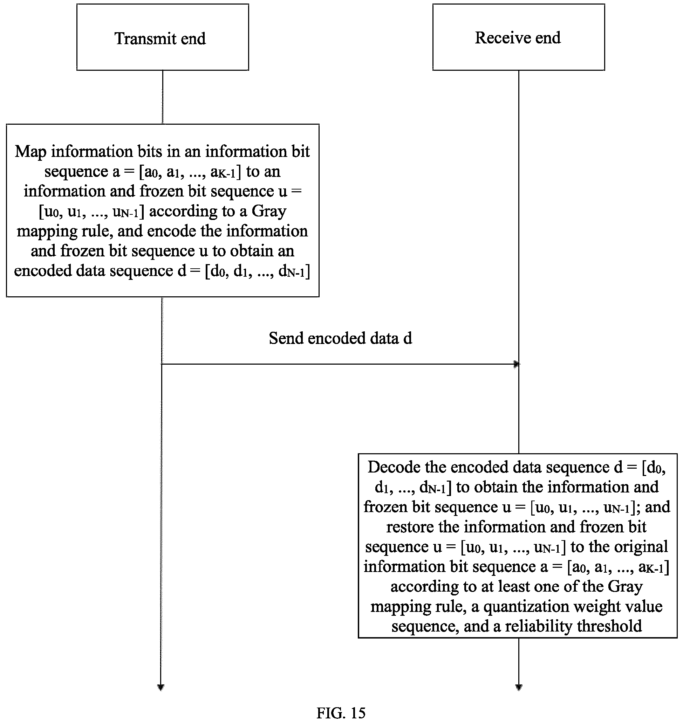

Referring to FIG. 15, the transmit end (a first transmission node 110) maps information bits in an information bit sequence a = [$a_0$, $a_1$, ..., $a_{k-1}$] to an information and frozen bit sequence u = [$u_0$, $u_1$, ..., $u_{N-1}$] according to a Gray mapping rule, and encodes the information and frozen bit sequence u to obtain an encoded data sequence d = [$d_0$, $d_1$, ..., $d_{N-1}$]. When receiving the encoded data sequence d = [$d_0$, $d_1$, ..., $d_{N-1}$] from the transmit end, the receive end (a second transmission node 120) decodes the encoded data sequence d = [$d_0$, $d_1$, ..., $d_{N-1}$] to obtain an information and frozen bit sequence u = [$u_0$, $u_1$, ..., $u_{N-1}$]; and restores the information and frozen bit sequence u = [$u_0$, $u_1$, ..., $u_{N-1}$] to the original information bit sequence a = [$a_0$, $a_1$, ..., $a_{k-1}$] according to at least one of the Gray mapping rule, a quantization weight value sequence, and a reliability threshold.

It can be understood that the process of restoring the encoded data sequence d to the original information bit sequence a is an inverse process of converting the information bit sequence a to the encoded data sequence d, and for the specific implementation principle, reference may be made to the implementation principle of the data processing method provided by the first aspect of the embodiments of the present disclosure, so the details will not be described in the embodiments of the present disclosure again.

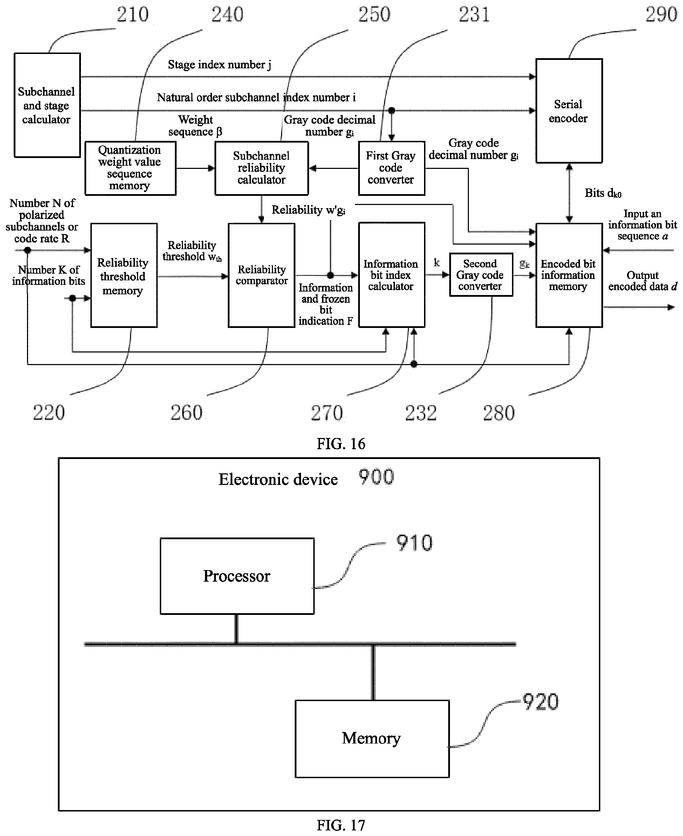

In accordance with a third aspect of the present disclosure, an embodiment a data processing apparatus. Referring to FIG. 16, the data processing apparatus includes at least one of:

a subchannel and stage calculator 210, configured for outputting a natural order subchannel index number and a serial stage index number;

a reliability threshold memory 220, configured for storing a reliability threshold;

a first Gray code converter 231, configured for converting the natural order subchannel index number to a first Gray code decimal number according to a Gray mapping rule;

a quantization weight value sequence memory 240, configured for storing a quantization weight value sequence;

a subchannel reliability calculator 250, configured for determining a subchannel reliability value according to the quantization weight value sequence and the subchannel index number;

a reliability comparator 260, configured for comparing the subchannel reliability value with the reliability threshold, and outputting an information and frozen bit indication according to a result of the comparison;

an information bit index calculator 270, configured for outputting an information bit index according to a number of information bits, a number of polarized subchannels, and the information and frozen bit indication;

a second Gray code converter 232, configured for converting the information bit index to a second Gray code decimal number;

an encoded bit information memory 280, configured for receiving and storing an information bit sequence which is inputted, determining an information and frozen bit sequence according to the information bit sequence, the first Gray code decimal number, and the second Gray code decimal number, and storing the information and frozen bit sequence; and

a serial encoder 290, configured for serially encoding the information and frozen bit sequence according to the serial stage index number and the natural order subchannel index number, and outputting an encoded data sequence, where the encoded bit information memory 280 is further configured for storing the encoded data sequence.

It can be understood that the apparatus shown in FIG. 16 can be applied to the first transmission node shown in FIG. 2 as an implementation framework for the first transmission node to perform data processing. The data processing apparatus provided by the embodiments of the present disclosure does not directly store the polar code sequence, but determines the position of information bits online, thereby reducing the storage complexity. A Gray code decimal number $g_i$ corresponding to i is obtained by a Gray code converter, such that the reliability value of the current subchannel can be quickly obtained according to the reliability value of the previous subchannel, thereby reducing multiplication operations and reducing the amount of calculation.

In an example, an initial value of the stage index number j in the subchannel and stage calculator 210 is equal to -1, an initial value of the subchannel index number i is equal to 0, and the stage index number j is increased by 1 after i has been counted to N-1 starting from 0. In an example, an initial value of the stage index number j in the subchannel and stage calculator 210 is equal to -1, an initial value of the subchannel index number i is equal to N-1, and the stage index number j is increased by 1 after i has been counted down to 0 starting from N-1. Stage-1 represents a stage where the information and frozen bit sequence u is obtained from the information bit sequence a. Stage 0, Stage 1, ..., Stage n-1 represent the stages where the encoded data sequence d is obtained from the information and frozen bit sequence u.

In an example, a reliability threshold $w_{th}$ is stored in the reliability threshold memory 220, and the reliability threshold is mapped to parameters including, but not limited to, an information bit sequence size K, a polarization matrix size N, and a code rate R.

In an example, the first Gray code converter 231 converts the subchannel index number i to a subchannel index number $g_i$ by Gray mapping, where $g_i$ is a Gray code decimal number corresponding to i and has a value which is an integer greater than or equal to 0 and less than N. In a specific example, i = 5, and $g_i$ = 7. In another specific embodiment, i = 6, and $g_i$ = 5.

In an example, data of a quantization weight value sequence $\beta = [\beta_{n-1}, \beta_{n-2}, ..., \beta 0]$ is stored in quantization weight value sequence memory 240. In a specific example, $\beta = [\beta_{n-1}, \beta_{n-2}, ..., \beta_0] = [197, 165, 139, 116, 98, 82, 68, 58, 49, 41]$ is stored in the quantization weight value sequence memory.

In an example, the subchannel reliability calculator 250 calculates the reliability value $w'_{g_i}$ of the $g_i^{th}$ subchannel according to the subchannel index number $g_i$ and the quantization weight value sequence $\beta$. In a specific example, n = 10, i = 5d = $B_9B_8B_7B_6B_5B_4B_3B_2B_1B_0$ = 0000000101b, $g_{i-1}$ = 6d = 00000110b, $w'_{g_{i-1}} = \mathbf{w'_6} =$ 107, $\beta = [\beta_{n-1}, \beta_{n-2}, ..., \beta_0] = [197, 165, 139, 116, 98, 82, 68, 58, 49, 41]$, the first non-zero bit in the binary expression of i is at a position e = 0, $g_i = g_{i-1} + (1-2 \cdot B_{e+1}) \cdot 2^e$ = 6 + (1-2×0)×$2^0$ = 7d, and $w'_{g_i} = W_{g_{i-1}} + (1 - 2. B_{e+1}) \cdot \beta_e$ = w'_6 +(1-2×$B_1$)×$\beta_0$ = 107 + (1-2×0)×41 = 148.

In an example, the reliability comparator 260 determines the information and frozen bit indication corresponding to the subchannel by comparing the reliability value $w'_{g_i}$ of the $g_i^{th}$ subchannel with the reliability threshold $w_{th}$; and the information and frozen bit indication corresponding to the $g_i^{th}$ subchannel is determined according to, for example, but not limited to, the following rules: when the reliability value $w'_{g_i}$ of the $g_i^{th}$ subchannel is greater than or equal to the reliability threshold $w_{th}$, the $g_i^{th}$ subchannel carries information bits, and when the reliability value $w'_{g_i}$ of the $g_i^{th}$ subchannel is less than the reliability threshold $w_{th}$, the $g_i^{th}$ subchannel carries frozen bits.

In an example, the information bit index calculator 270 calculates a position k where an information bit is located. In a specific example, u = [$u_0$, $u_1$, ..., $u_{N-1}$], the information and frozen bit sequence is adjusted, the initial value of the information index number is set to k = N-k, the Gray code decimal number $g_k$ corresponding to the initial value k of the information index number points to the first information bit $a_0$, the initial value of the subchannel index number is $g_i$, and i = 0. For i = 0, 1, ..., N-1, if k ≤ N-1 and F = 1, $u_{g_i} = u_{g_k}$, k = k + 1, and i = i + 1; otherwise, $u_{g_i}$ = 0, and i = i + 1.

In an example, an information bit sequence a, an information and frozen bit sequence u, and encoded data d are stored in the encoded bit information memory 280. In an example, an information bit sequence is initially inputted to the encoded bit information memory 280. In a specific example, u = [0, ..., 0, $a_0$, $a_1$, ..., $a_{K-1}$] is converted to an initial information and frozen bit sequence by Gray transform. In an example, the stage index number is j = -1, and after i has been counted to N-1 starting from 0 or i has been counted down to 0 starting from N-1, an information and frozen bit sequence u = [$u_0$, $u_1$, ..., $u_{N-1}$] is obtained from the encoded bit information memory 280. In an example, the stage index number is j = n-1, and encoded data d = [$d_0$, $d_1$, ..., $d_{N-1}$] is outputted from the encoded bit information memory 280.

In an example, the serial encoder 290 encodes data of the information and frozen bit sequence in the encoded bit information memory 280 to obtain encoded data. In a specific example, i is an even subchannel index number expressed in binary form as i = $B_{n-1}B_{n-2}...B_{j+1}B_jB_{j-1}...B_2B_10$, k0 = $B_{n-1}B_{n-2}...B_{j+1}0B_{j-1}...B_2B_1B_j$, k1 = $B_{n-1}B_{n-2}...B_{j+1}1B_{j-1}...B_2B_1B_j$, and the serial encoder 290 performs at least the following operation on the information and frozen bit sequence u = [$u_0$, $u_1$, ..., $u_{N-1}$] in the encoded bit information memory 280: $u_{k0} = (u_{k0} + u_{k1}) \mod 2$. The updated data $u_{k0}$ is written to the $k0^{th}$ position of the encoded bit information memory 280.

In the several embodiments provided in the present disclosure, it is to be understood that the disclosed apparatus and method may be implemented in other manners. For example, the described apparatus embodiments are only exemplary. For example, the division of the modules or units is merely a logical function division and other division manners may be used in practical implementations. For example, a plurality of units or components may be combined or integrated into another apparatus, or some features may be ignored or not performed. In addition, the shown or discussed mutual couplings or direct couplings or communication connections may be implemented through some interfaces. The indirect couplings or communication connections between the apparatus or units may be implemented in electronic, mechanical, or other forms.

It should be noted that the information exchange and execution processes between the apparatus or units are based on the same idea as the method embodiments of the present disclosure. For specific functions and technical effects of the modules, reference may be made to the descriptions in the method embodiments, and the details will not be repeated herein.

It can also be understood that although the operations in the embodiments of the present disclosure are described in a particular order in the drawings, it should not be construed as requiring that these operations be performed in a particular or serial order as shown, or that all of the illustrated operations be performed to achieve a desired result. In a particular environment, multitasking and parallel processing may be advantageous.

Referring to FIG. 17, in accordance with a fourth aspect of the present disclosure, an embodiment provides an electronic device 900, including, but not limited to,

at least one processor 910; and
at least one memory 920, configured for storing at least one program;
where the at least one program, when executed by the at least one processor 910, causes the at least one processor 910 to implement the data processing method according to any one of the above embodiments.

It should be noted that the processor 910 and the memory 920 may be connected by a bus or in other ways.

It can be understood that the processor 910 may be a Central Processing Unit (CPU). The processor may also be other general-purpose processor, a Digital Signal Processor (DSP), an Application-Specific Integrated Circuit (ASIC), a Field Programmable Gate Array (FPGA), or other programmable logic device, discrete gate or transistor logic device, discrete hardware component, or the like. The general-purpose processor may be a microprocessor or any conventional processor or the like. Alternatively, the processor 910 uses one or more integrated circuits for executing related programs to implement the technical schemes provided in the embodiments of the present disclosure.

The memory 920, as a non-transitory computer-readable storage medium, may be configured for storing a non-transitory software program and a non-transitory computer-executable program, for example, the data processing method executed by an electronic device according to any one of the embodiments of the present disclosure. The processor 910 runs the non-transitory software program and the non-transitory computer-executable program stored in the memory 920, to implement the data processing method.

The memory 920 may include a program storage area and a data storage area. The program storage area may store an operating system, and an application required by at least one function. The data storage area may store data and the like required for executing the data processing method. In addition, the memory 920 may include a high-speed random access memory, and may also include a non-transitory memory, e.g., at least one magnetic disk storage device, flash memory device, or other non-transitory solid-state storage device. In some implementations, the memory 920 optionally includes memories located remotely from the processor 910, and the remote memories may be connected to the processor 910 via a network. Examples of the network include, but not limited to, the Internet, an intranet, a local area network, a mobile communication network, and combinations thereof.

The non-transitory software program and instructions required to implement the data processing method are stored in the memory 920 which, when executed by one or more processors 910, cause the one or more processors 910 to implement the data processing method according to any one of the embodiments of the present disclosure.

An embodiment of the present disclosure provides a computer-readable storage medium, having a processor-executable program stored therein. The processor-executable program, when executed by a processor, causes the processor to implement the data processing method according to any one of the above embodiments.

The computer-readable storage medium in the embodiment of the present disclosure may be any combination of one or more computer-readable media. The computer-readable medium may be a computer-readable signal medium or a computer-readable storage medium. For example, the computer-readable storage medium may include, but not limited to, an electrical, magnetic, optical, electromagnetic, infrared, or semiconductor system, apparatus, or device, or any combination thereof. Specific examples (not exhaustive) of the computer-readable storage medium include: an electrical connection having one or more wires, a portable computer disk, a hard disk, a Random Access Memory (RAM), a Read-Only Memory (ROM), an erasable programmable Read-Only Memory (EPROM), a flash memory, an optical fiber, a portable Compact Disc Read-Only Memory (CD-ROM), an optical storage device, a magnetic storage device, or any suitable combination thereof. In the present disclosure, the computer-readable storage medium may be any tangible medium containing or storing a program that may be used by or in combination with an instruction execution system, apparatus, or device.

The computer-readable signal medium may include a data signal propagated in a baseband or as part of a carrier. The data signal carries computer-readable program code. Such a propagated data signal may be in a variety of forms including, but not limited to, an electromagnetic signal, an optical signal, or any suitable combination thereof. The computer-readable signal medium may also be any computer-readable medium other than a computer-readable storage medium, and may send, propagate, or transmit a program for use by or in combination with an instruction execution system, apparatus, or device.

The program code contained on the computer-readable medium may be transmitted using any suitable medium, including but not limited to, via wireless transmission, via a wire, via a fiber optic cable, via Radio Frequency (RF), etc., or any suitable combination thereof.

Computer program code for executing the operations of the present disclosure may be compiled in one or more programming languages or a combination of programming languages, including object-oriented programming languages such as Java, Smalltalk, and C++, and conventional procedural programming languages such as the "C" language or similar programming languages. The program code can be entirely executed on a user's computer, partly executed on the user's computer, executed as a separate software package, partly executed on the user's computer and partly executed on a remote computer, or entirely executed on a remote computer or server. In cases involving a remote computer, the remote computer may be connected to the user's computer via any type of network, including a Local Area Network (LAN) or a Wide Area Network (WAN), or may be connected to an external computer (e.g., via an Internet service provided by an Internet service provider).

An embodiment of the present disclosure provides a computer program product, storing computer instructions which, when executed by a computer, cause the computer to implement the data processing method according to any one of the above embodiments.

Although some embodiments of the present disclosure have been described above, the present disclosure is not limited to the implementations described above. Those having ordinary skills in the art can make various equivalent modifications or replacements without departing from the scope of the present disclosure. Such equivalent modifications or replacements fall within the scope defined by the claims of the present disclosure.

**Claims**

1. A data processing method, comprising:

   acquiring an information bit sequence, wherein the information bit sequence comprises K information bits, and K is an integer greater than 0;
   mapping information bits in the information bit sequence to an information and frozen bit sequence according to a Gray mapping rule, wherein the information and frozen bit sequence comprises N bits, N represents a number of polarized subchannels, and N is an integer greater than K;
   encoding the information and frozen bit sequence to obtain an encoded data sequence; and
   sending the encoded data sequence.

2. The method of claim 1, wherein mapping information bits in the information bit sequence to an information and frozen bit sequence according to a Gray mapping rule comprises:

   mapping the information bits in the information bit sequence to an initial information and frozen bit sequence;
   determining a subchannel reliability value corresponding to each of the polarized subchannels according to the Gray mapping rule, a natural order subchannel index number, and a quantization weight value sequence;
   determining an information and frozen bit indication corresponding to each of the polarized subchannels according to the subchannel reliability values corresponding to the polarized subchannels and a reliability threshold; and
   updating the initial information and frozen bit sequence according to the information and frozen bit indications corresponding to the polarized subchannel to obtain the information and frozen bit sequence.

3. The method of claim 2, wherein mapping the information bits in the information bit sequence to an initial information and frozen bit sequence comprises one of:

   setting a $j^{th}$ information bit $a_j$ in the information bit sequence at a $g_{N-K+j}^{th}$ position in the initial information and frozen bit sequence; or
   setting a $(K-1-j)^{th}$ information bit $a_{K-1-j}$ in the information bit sequence at a $g_{N-K+j}^{th}$ position in the initial information and frozen bit sequence; or

setting a j$^{th}$ information bit $a_j$ in the information bit sequence at a $g_j$ position in the initial information and frozen bit sequence; or

setting a (K-1-j)$^{th}$ information bit $a_{K-1-j}$ in the information bit sequence at a $g_j^{th}$ position in the initial information and frozen bit sequence,

wherein j is any integer from 0 to K-1, and $g_j$ is a Gray code decimal number corresponding to j.

4. The method of claim 2, wherein determining a subchannel reliability value corresponding to each of the polarized subchannels according to the Gray mapping rule, a natural order subchannel index number, and a quantization weight value sequence comprises at least one of:

calculating a reliability value $w'_{g_i}$ of a $g_i^{th}$ polarized subchannel according to the quantization weight value sequence, wherein $g_i$ is a Gray code decimal number obtained by converting a natural order subchannel index number i according to the Gray mapping rule, the natural order subchannel index number i is any integer from 0 to N-1, the quantization weight value sequence comprises n quantization weight values, and N is less than or equal to an n$^{th}$ power of 2; or

calculating a reliability value $w'_{g_{i+1}}$ of a $g_{i+1}^{th}$ subchannel according to a reliability value $w'_{g_i}$ of a $g_i^{th}$ subchannel, wherein $g_i$ is a Gray code decimal number obtained by converting a natural order subchannel index number i according to the Gray mapping rule, the natural order subchannel index number i takes values in ascending order as 0, 1, 2, ..., N-1, the quantization weight value sequence comprises n quantization weight values, and N is less than or equal to an n$^{th}$ power of 2; or

calculating a reliability value $w'_{g_i}$ of a $g_i^{th}$ subchannel according to a reliability value $w'_{g_{i+1}}$ of a $g_{i+1}^{th}$ subchannel, wherein $g_i$ is a Gray code decimal number obtained by converting a natural order subchannel index number i according to the Gray mapping rule, the natural order subchannel index number i takes values in descending order as N-1, N-2, N-3, ..., 0, the quantization weight value sequence comprises n quantization weight values, and N is less than or equal to an n$^{th}$ power of 2;

5. The method of claim 2, wherein the initial information and frozen bit sequence is expressed as a formula u = [$u_0$, $u_1$, ..., $u_{N-1}$], and updating the initial information and frozen bit sequence according to the information and frozen bit indications corresponding to the polarized subchannel to obtain the information and frozen bit sequence comprises:

traversing the natural order subchannel index numbers sequentially or in reverse order, and executing the following operations for the natural order subchannel index number i currently being traversed: acquiring an information and frozen bit indication corresponding to a $g_i^{th}$ polarized subchannel; adjusting a bit at a $g_i^{th}$ position in u to a $g_k^{th}$ position in u, in response to the information and frozen bit indication corresponding to the $g_i^{th}$ polarized subchannel being a first indication value; setting the bit at the $g_i^{th}$ position in u to 0, in response to the information and frozen bit indication corresponding to the $g_i^{th}$ polarized subchannel being a second indication value; and obtaining the information and frozen bit sequence after the traversal of all the natural order subchannel index numbers is completed,

wherein k represents an information bit index, k is any integer from 0 to K-1 or any integer from N-K to N, $g_i$ represents a Gray code decimal number corresponding to i, and $g_k$ represents a Gray code decimal number corresponding to k.

6. The method of claim 2, wherein n quantization weight values in the quantization weight value sequence are arranged in ascending order or descending order; and an m$^{th}$ quantization weight value in the quantization weight value sequence represents a quantization weight value corresponding to an m$^{th}$ bit in a binary expression of the natural order subchannel index number, and m is any integer from 0 to n-1.

7. The method of claim 6, wherein a sum of all quantization weight values in the quantization weight value sequence is less than a first value, wherein the first value is a positive integer power of 2.

8. The method of claim 7, wherein the first value comprises one of: 256, 512, 1024, 2048, or 4096.

9. The method of claim 2, wherein the quantization weight value sequence is determined by at least one of:

presetting the quantization weight value sequence; or

determining the quantization weight value sequence according to a constraint condition that a number of differences between a quantized polar weight sequence obtained by the quantization weight value sequence and a polar weight sequence is not greater than a second value, wherein the second value is an integer greater than or equal to 0 and less than or equal to N.

10. The method of claim 2, wherein the reliability threshold is obtained from a preset mapping relationship according to an index value, the index value is determined according to at least one of a value of K, a value of N, and a value of a code rate R, and the mapping relationship comprises at least one of: a mapping formula, a mapping table, or a mapping graph.

11. The method of claim 2, wherein determining an information and frozen bit indication corresponding to each of the polarized subchannels according to the subchannel reliability values corresponding to the polarized subchannels and a reliability threshold comprises:

in response to the subchannel reliability value corresponding to the polarized subchannel being greater than or equal to the reliability threshold, the information and frozen bit indication corresponding to the polarized subchannel is a first indication value, and the first indication value indicates that the polarized subchannel carries an information bit; and

in response to the subchannel reliability value corresponding to the polarized subchannel being less than the reliability threshold, the information and frozen bit indication corresponding to the polarized subchannel is a second indication value, and the second indication value indicates that the polarized subchannel carries a frozen bit.

12. The method of claim 1, wherein the information bit sequence is expressed as a formula $a = [a_0, a_1, ..., a_{K-1}]$, the information and frozen bit sequence is expressed as a formula $u = [u_0, u_1, ..., u_{N-1}]$, and the information bit sequence and the information and frozen bit sequence satisfy the following mapping relationship: $u_{f1(j)} = a_{f2(j)}$, wherein $f1(j) \in \{0, 1, ..., N-1\}$, $f2(j) \in \{0, 1, ..., K-1\}$, and $j \in \{0, 1, ..., K-1\}$.

13. The method of claim 12, wherein f1 is a function of j, and is determined according to f2(j), a Gray map, an information and frozen bit indication, and an information index number; and f2 is a function of j, and comprises f(j)=j or f(j)=K-j.

14. The method of claim 1, wherein encoding the information and frozen bit sequence to obtain an encoded data sequence comprises:

acquiring an n-stage serial encoder, wherein the n-stage serial encoder is configured for performing n-stage serial encoding, and in each stage of serial encoding, bits in the information and frozen bit sequence are encoded in groups of two; and wherein two bits are respectively expressed as a $k0^{th}$ bit and a $k1^{th}$ bit, k0 represents a decimal number obtained by exchanging a $j^{th}$ bit and a lowest bit of a subchannel i, k1 represents a decimal number obtained by exchanging a $j^{th}$ bit and a lowest bit of a subchannel i+1, $i \in \{0, 2, 4, ..., N-2\}$, j represents a serial encoding stage, $j \in \{0, 1, 2, ..., n-1\}$, and $n=\log_2 N$; and

encoding the information and frozen bit sequence by using the n-stage serial encoder to obtain the encoded data sequence.

15. A data processing method, comprising:

receiving an encoded data sequence sent by a transmit end, wherein the encoded data sequence comprises N pieces of encoded data, and

the encoded data sequence is obtained by performing the following operations: mapping information bits in an information bit sequence to an information and frozen bit sequence according to a Gray mapping rule, and encoding the information and frozen bit sequence to obtain the encoded data sequence, wherein the information bit sequence comprises K information bits, K is an integer greater than 0, the information and frozen bit sequence comprises N bits, N represents a number of polarized subchannels, and N is an integer greater than K.

16. A data processing apparatus, comprising at least one of:

a subchannel and stage calculator, configured for outputting a natural order subchannel index number and a serial stage index number;
a reliability threshold memory, configured for storing a reliability threshold;

a first Gray code converter, configured for converting the natural order subchannel index number to a first Gray code decimal number according to a Gray mapping rule;

a quantization weight value sequence memory, configured for storing a quantization weight value sequence;

a subchannel reliability calculator, configured for determining a subchannel reliability value according to the quantization weight value sequence and the subchannel index number;

a reliability comparator, configured for comparing the subchannel reliability value with the reliability threshold, and outputting an information and frozen bit indication according to a result of the comparison;

an information bit index calculator, configured for outputting an information bit index according to a number of information bits, a number of polarized subchannels, and the information and frozen bit indication;

a second Gray code converter, configured for converting the information bit index to a second Gray code decimal number;

an encoded bit information memory, configured for receiving and storing an information bit sequence which is inputted, determining an information and frozen bit sequence according to the information bit sequence, the first Gray code decimal number, and the second Gray code decimal number, and storing the information and frozen bit sequence; and

a serial encoder, configured for serially encoding the information and frozen bit sequence according to the serial stage index number and the natural order subchannel index number, and outputting an encoded data sequence, wherein the encoded bit information memory is further configured for storing the encoded data sequence.

17. An electronic device, comprising:

at least one processor; and
at least one memory, configured for storing at least one program,
wherein the at least one program, when executed by the at least one processor, causes the at least one processor to perform the data processing method of any one of claims 1 to 15.

18. A computer-readable storage medium, storing a processor-executable program, wherein the processor-executable program, when executed by a processor, causes the processor to perform the data processing method of any one of claims 1 to 15.

19. A computer program product, comprising a computer program or a computer instruction stored in a computer-readable storage medium, wherein the computer program or computer instruction, when read from the computer-readable storage medium and executed by a processor of a computer device, causes the computer device to perform the data processing method of any one of claims 1 to 15.

```
k = 0;
For i = 0, 1, 2, ..., N-1
    uᵢ = 0;
    If i ∈ Q
        uᵢ = aₖ;
        k = k + 1;
    End
End
```

FIG. 1a

FIG. 1b

FIG. 2

FIG. 3

```
n = log₂N;
For i = 0, 1, ..., n-1;
      For j = 0, 1, ..., N/2^(i+1)-1;
      If (j mod 2) = 1
            For k = 0, 1, ..., 2^i-1;
                  Index0 = j*2^i + k;
                  Index1 = 2^i + j*2^(i+1) + k;
                  Buffer = u_Index0;
                  u_Index0 = u_Index1;
                  u_Index1 = Buffer ;
            End
      End
End
```

FIG. 4

```
For j = 0, 1, ..., N-1;
      If   j < K
                  u_{g_{N-K+j}}  =  a_j ;
      Else
                  u_{g_{j-K}}  = 0;
      End
End
```

FIG. 5

```
For j = 0, 1, ..., N-1;
      If   j < K
                  u_{g_{N-K+j}}  =  a_{K-1-j};
      Else
                  u_{g_{j-K}}  = 0;
      End
End
```

FIG. 6

```
For j = 0, 1, ..., N-1;
      If   j < K
                  u_{g_j}  =  a_j ;
      Else
                  u_{g_j}  = 0;
      End
End
```

FIG. 7

```
For j = 0, 1, ..., N-1;
    If   j < K
```
$$u_{g_j} = a_{K-1-j};$$
```
    Else
```
$$u_{g_j} = 0;$$
```
    End
End
```

FIG. 8

```
k = K - 1;
u = [u0, u1, ..., uN-1];
For i = N-1, N-2, N-3, ..., 1, 0
    If   F = 1 &&   k ≥ 0
```
$$u_{g_i} = u_{g_k};$$
```
        k = k - 1;
    Else
```
$$u_{g_i} = 0;$$
```
    End
End
```

FIG. 9

```
k = N - K;
u = [u0, u1, ..., uN-1];
For i = 0, 1, 2, ..., N-1
    If   F = 1 && k ≤ N-1
```
$$u_{g_i} = u_{g_k};$$
```
        k = k + 1;
    Else
```
$$u_{g_i} = 0;$$
```
    End
End
```

FIG. 10

```
k = K - 1;
u = [u0, u1, ..., uN-1];
For i = N-1, N-2, N-3, ..., 1, 0
    If   F = 1   &&   k ≥ 0
```
$$u_{g_i} = u_{g_k};$$
```
        k = k - 1;
    Else
```
$$u_{g_i} = 0;$$
```
    End
End
```

FIG. 11

```
k = N - K;
u = [u_0, u_1, ..., u_{N-1}];
For i = 0, 1, 2, ..., N-1
      If   F = 1   &&   k ≤ N-1
          u_{g_i}  =  u_{g_k} ;
          k = k + 1;
      Else
          u_{g_i}  = 0;
      End
End
```

FIG. 12

```
For j = 0, 1, 2, ..., n-1
   For i = 0, 2, 4, ..., N-2
      k0 = exchange a j^{th} bit and a lowest bit of i
      k1 = exchange a j^{th} bit and a lowest bit of i+1
      u_{k0} = (u_{k0} + u_{k1} ) mod 2;
   End
End
```

FIG. 13

```
For j = 0, 1, 2, ..., n-1
   For i = N-2, N-4, N-6, ..., 0
      k0 = exchange a j^{th} bit and a lowest bit of i
      k1 = exchange a j^{th} bit and a lowest bit of i+1
      u_{k0} = (u_{k0} + u_{k1} ) mod 2;
   End
End
```

FIG. 14

Transmit end

Receive end

Map information bits in an information bit sequence $a = [a_0, a_1, ..., a_{K-1}]$ to an information and frozen bit sequence $u = [u_0, u_1, ..., u_{N-1}]$ according to a Gray mapping rule, and encode the information and frozen bit sequence u to obtain an encoded data sequence $d = [d_0, d_1, ..., d_{N-1}]$

Send encoded data d

Decode the encoded data sequence $d = [d_0, d_1, ..., d_{N-1}]$ to obtain the information and frozen bit sequence $u = [u_0, u_1, ..., u_{N-1}]$; and restore the information and frozen bit sequence $u = [u_0, u_1, ..., u_{N-1}]$ to the original information bit sequence $a = [a_0, a_1, ..., a_{K-1}]$ according to at least one of the Gray mapping rule, a quantization weight value sequence, and a reliability threshold

FIG. 15

210  240  250  231  290

Subchannel
and stage
calculator

Stage index number j

Natural order subchannel index number i

Serial
encoder

Weight
sequence β

Gray code decimal
number $g_i$

Quantization
weight value
sequence
memory

Subchannel
reliability
calculator

First Gray
code
converter

Gray code
decimal number $g_i$

Number N of
polarized
subchannels or
code rate R

Reliability $w'_{g_i}$

Bits $d_{k0}$

Number K of
information bits

Reliability
threshold $w_{th}$

Reliability
threshold
memory

Reliability
comparator

Information
and frozen
bit
indication F

Information
bit index
calculator

k

Second
Gray code
converter

$g_k$

Encoded bit
information
memory

Input an
information bit
sequence $a$

Output
encoded data $d$

220  260  270  232  280

FIG. 16

Electronic device  900

Processor  910

Memory  920

FIG. 17

## INTERNATIONAL SEARCH REPORT

| International application No. |
| --- |
| **PCT/CN2023/132941** |

| A. | CLASSIFICATION OF SUBJECT MATTER |
| --- | --- |

H03M13/13(2006.01)i

According to International Patent Classification (IPC) or to both national classification and IPC

| B. | FIELDS SEARCHED |
| --- | --- |

Minimum documentation searched (classification system followed by classification symbols)

IPC:H03M13

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: Polar, 极化, 编码, 格雷, 映射, 冻结, 比特, 信道, 索引, 权重, 可靠度, encode, gray, map, frozen, bit, channel, index, weight, reliability

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 111342934 A (SOUTHEAST UNIVERSITY et al.) 26 June 2020 (2020-06-26) description, paragraphs 78-130 | 1, 12-13, 15, 17-19 |
| X | CN 107493154 A (ZTE CORP.) 19 December 2017 (2017-12-19) description, paragraphs 45-57 | 1, 12-13, 15, 17-19 |
| A | CN 109032834 A (NANJING UNIVERSITY OF POSTS AND TELECOMMUNICATIONS) 18 December 2018 (2018-12-18) entire document | 1-19 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

"T"　later document published after the international filing date or priority date and not in conflict with the application but cited to understand the principle or theory underlying the invention

"X"　document of particular relevance; the claimed invention cannot be considered novel or cannot be considered to involve an inventive step when the document is taken alone

"Y"　document of particular relevance; the claimed invention cannot be considered to involve an inventive step when the document is combined with one or more other such documents, such combination being obvious to a person skilled in the art

"&"　document member of the same patent family

| Date of the actual completion of the international search | Date of mailing of the international search report |
| --- | --- |
| **05 February 2024** | **07 February 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/132941**

| Patent document cited in search report | | | Publication date (day/month/year) | Patent family member(s) | | | Publication date (day/month/year) |
|---|---|---|---|---|---|---|---|
| CN | 111342934 | A | 26 June 2020 | CN | 111342934 | B | 11 November 2022 |
| CN | 107493154 | A | 19 December 2017 | CN | 107493154 | B | 18 June 2021 |
| CN | 109032834 | A | 18 December 2018 | CN | 109032834 | B | 09 July 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211557600